# EUROPEAN PATENT APPLICATION

(11) **EP 4 538 019 A1**
(43) Date of publication of application: **16.04.2025**
(21) Application number: 23823776.2
(22) Date of filing: 06.06.2023
(51) Int. Cl.: B29C 59/02, H01L 21/027

(54) **CURABLE COMPOSITION, METHOD FOR FORMING INVERTED PATTERN, METHOD FOR FORMING FILM, AND METHOD FOR PRODUCING ARTICLE**

(30) Priority: 13.06.2022 JP 2022095226; 05.06.2023 JP 2023092681
(71) Applicant: CANON KABUSHIKI KAISHA, Tokyo 146-8501 (JP)
(72) Inventor: OOTSUKA, Masanobu, Tokyo 146-8501 (JP); ITO, Toshiki, Tokyo 146-8501 (JP)
(74) Representative: TBK
(86) International application number: PCT/JP2023/020957
(87) International publication number: WO 2023/243484

(57) **Abstract**

A new technique relating to a curable composition is provided. A curable composition contains a polymerizable compound, a photopolymerization initiator, and a solvent. The polymerizable compound contains a silicon compound having polymerizability, the curable composition has a viscosity of not less than 2 mPa·s and not more than 60 mPa·s at 23°C, the curable composition in a state in which the solvent is removed has a viscosity of not less than 30 mPa·s and not more than 10,000 mPa·s at 23°C, and content of the solvent with respect to the whole curable composition is not less than 5 vol% and not more than 95 vol%.

## Description

### TECHNICAL FIELD

The present invention relates to a curable composition, an inverted pattern forming method, a film forming method, and an article manufacturing method.

### BACKGROUND ART

For semiconductor devices and MEMS, requirements of micronization are increasing, and as a micropatterning technique, an imprint technique (optical imprint technique) has received a great deal of attention as a microfabrication technique. In the imprint technique, a curable composition is cured in a state in which a mold with a fine concave-convex pattern formed on the surface is in contact with the curable composition supplied (applied) onto a substrate. Thus, the pattern of the mold is transferred to the cured film of the curable composition, thereby forming the pattern on the substrate. According to the imprint technique, it is possible to form, on a substrate, a fine pattern (structure) on a several nanometer order (see PTL 1).

An example of a pattern forming method using the imprint technique will be described here. First, a curable composition in liquid form is discretely dropped (arranged) in a pattern formation region on a substrate. The droplets of the curable composition arranged in the pattern formation region spread on the substrate. This phenomenon can be called pre-spreading. Next, a mold is pressed against the curable composition on the substrate. Thus, the droplets of the curable composition spread to the whole region of the gap between the substrate and the mold by a capillary phenomenon. This phenomenon can be called spreading. By the capillary phenomenon, the curable composition fills recesses forming the pattern of the mold. This phenomenon can be called filling. The time until spreading and filling are completed can be called a filling time. If the filling of the curable composition is completed, the curable composition is irradiated with light to cure the curable composition. Then, the mold is released from the cured curable composition on the substrate. By executing these steps, the pattern of the mold is transferred to the curable composition on the substrate, and the pattern of the curable composition is formed.

A photolithography step of fabricating a semiconductor device requires planarization of a substrate. For example, in an extreme ultraviolet exposure technique (EUV) as a photolithography technique attracting attention in recent years, the depth of focus at which a projected image is formed decreases as miniaturization advances, so the unevenness on the surface of a substrate to which a curable composition is supplied must be decreased to a few tens nm or less. Flatness equivalent to that of EUV is required in an imprint technique as well, in order to improve the filling properties of a curable composition and the line width accuracy (see NPL 1). As a planarization technique, there is known a technique of obtaining a flat surface by discretely dropping, on an uneven substrate, droplets of a curable composition in an amount corresponding to the unevenness, and curing the curable composition in a state in which a mold having a flat surface is in contact with the curable composition (see PTLs 2 and 3).

In the conventional pattern forming method or planarization technique, however, if the mold is brought into contact with the droplets dropped on the substrate in a state in which the droplets are not in contact with each other, bubbles involved between the droplets in the space between the droplet and the substrate become large. Hence, long time is needed until the bubbles are diffused to the mold and/or the substrate and disappear, and this may be one of factors that lower the productivity (throughput).

### CITATION LIST

### PATENT LITERATURE

PTL 1: Japanese Patent No. 6,584,578
PTL 2: Japanese Patent Laid-Open No. 2019-140394
PTL 3: US-2020-0286740
PTL 4: Japanese Patent Laid-Open No. 2009-503139

### NON PATENT LITERATURE

NPL 1: Proc. SPIE 11324-11 (2020)

### SUMMARY OF INVENTION

The present invention provides a novel technique related to a curable composition.

According to one aspect of the present invention, there is provided a curable composition containing a polymerizable compound, a photopolymerization initiator, and a solvent, wherein the polymerizable compound contains a silicon compound having polymerizability, the curable composition has a viscosity of not less than 2 mPa·s and not more than 60 mPa·s at 23°C, the curable composition in a state in which the solvent is removed has a viscosity of not less than 30 mPa·s and not more than 10,000 mPa·s at 23°C, and content of the solvent with respect to the whole curable composition is not less than 5 vol% and not more than 95 vol%.

Further objects or other aspects of the present invention will become apparent from the following detailed description of the embodiments with reference to the accompanying drawings.

### BRIEF DESCRIPTION OF DRAWINGS

The accompanying drawings, which are incorporated in and constitute a part of the specification, illustrate embodiments of the invention and, together with the description, serve to explain principles of the invention.
Fig. 1 is a view for explaining a pattern forming method (film forming method) according to an embodiment;
Fig. 2 is a view for explaining the flow behavior of the droplets of a curable composition during a waiting step;
Fig. 3 is a view showing comparison between a contact step in the related art and a contact step according to an embodiment; and
Fig. 4 is a view for explaining an inverting process.

### DESCRIPTION OF EMBODIMENTS

Hereinafter, embodiments will be described in detail with reference to the accompanying drawings. It should be noted that the following embodiments are not intended to limit the scope of the appended claims. A plurality of features are described in the embodiments, but not all the plurality of features are necessarily essential to the present invention, and the plurality of features may arbitrarily be combined. Also, in the accompanying drawings, the same reference numerals denote the same or similar parts, and a repetitive description will be omitted.

To provide a new technique concerning a curable composition, the present inventors found a curable composition and process conditions therefor, which can form a practically continuous liquid film before the droplets of a curable composition discretely dropped (arranged) on a substrate combine with each other and a mold comes into contact with the curable composition.

### [Curable Composition]

A curable composition (A) according to an embodiment can be a curable composition for inkjet. The curable composition (A) according to the embodiment is a composition containing a component (as) that is a silicon compound having polymerizability, a component (b) that is a photopolymerization initiator, and a component (d) that is a solvent. The curable composition (A) according to the embodiment may further contain at least one of a polymerizable compound (a) and a nonpolymerizable compound (c) containing no silicon (Si) atoms.

In this specification, a cured film means a film obtained by polymerizing the curable composition on a substrate and thus curing it. Note that the shape of the cured film is not particularly limited, and the cured film may have a pattern shape on the surface, or may not.

### <Component (as): Silicon-containing Polymerizable Compound>

A silicon compound as the component (as) may be understood as a silicon-containing polymerizable compound. **In** this specification, the silicon-containing polymerizable compound is a compound that reacts with a polymerizing factor (for example, a radical) generated from a photopolymerization initiator (the component (b)), and forms a film made of a polymer compound by a chain reaction (polymerization reaction).

An example of the silicon-containing polymerizable compound is a radical polymerizable compound. The polymerizable compound as the component (aa) can be formed by only one type of a polymerizable compound, and can also be formed by a plurality of types of polymerizable compounds.

Examples of the silicon-containing radical polymerizable compound are a (meth)acrylate-based compound, a (meth)acrylamide-based compound, a vinylbenzene-based compound, an aryl ether-based compound, a vinyl ether-based compound, and a maleimide-based compound.

The silicon-containing polymerizable compound (as) can be linear or branched. As the silicon-containing polymerizable compound, for example, the following structures can be used. An example of a polymerizable functional group in a group Q having a polymerizable functional group is a radical polymerizable functional group. Detailed examples of the radical polymerizable functional group are a (meth)acrylate-based compound, a (meth)acrylamide-based compound, a vinylbenzene-based compound, an aryl ether-based compound, a vinyl ether-based compound, and a maleimide-based compound. The group Q having a polymerizable functional group can be a group having the above-described polymerizable functional group.

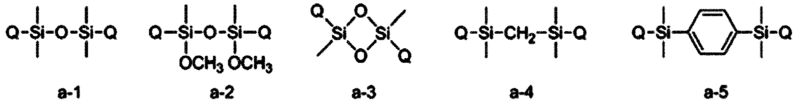

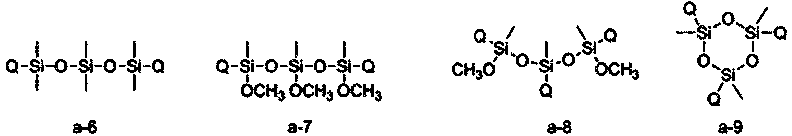

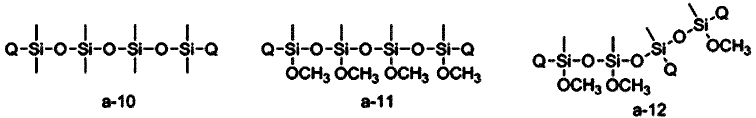

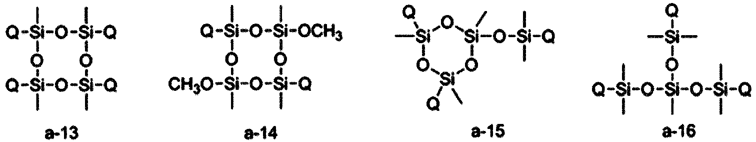

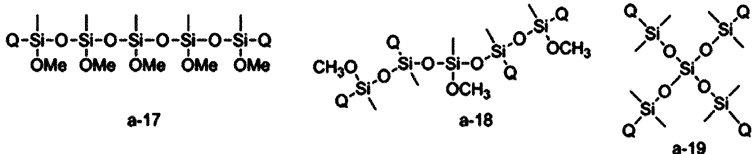

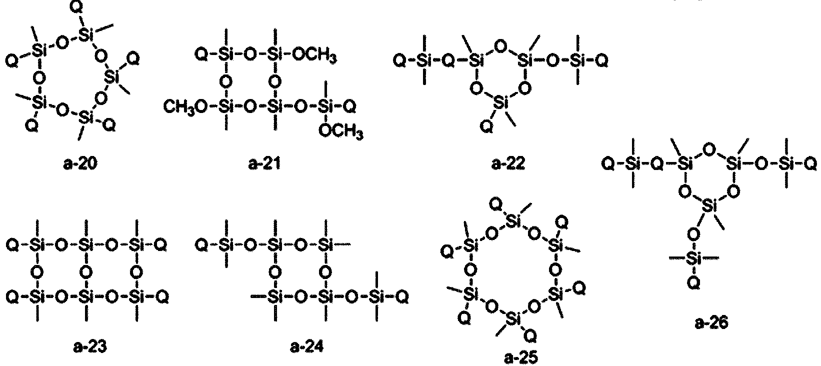

Examples of the silicon-containing polymerizable compound (as) are a silsesquioxane skeleton indicated by formula (1) below and a silicone skeleton indicated by formula (2) below. Here, in formula (1), m + n = 8 (8 ≥ m ≥ 1), and R₁ is a bivalent organic group. Also, in formula (2), A, B, R₂, and R₃ are an alkyl group, a cycloalkyl group, an alkoxy group, a phenyl group, or a hydroxyl group having a carbon number of 1 to 6 independently (t is an integer of 1 to 3), and at least one of A and B is a polymerizable functional group.

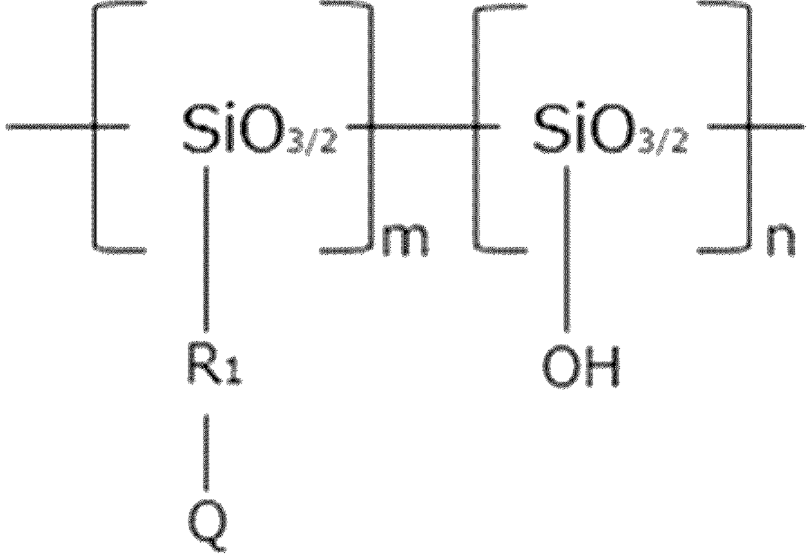

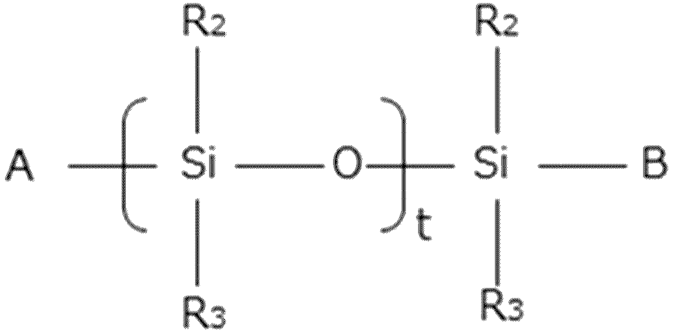

An example of a polymerizable functional group in groups Q, A, and B having a polymerizable functional group is a radical polymerizable functional group. Detailed examples of the radical polymerizable functional group are a (meth)acrylate-based compound, a (meth)acrylamide-based compound, a vinylbenzene-based compound, an aryl ether-based compound, a vinyl ether-based compound, and a maleimide-based compound. The group Q having a polymerizable functional group can be a group having the above-described polymerizable functional group.

A silicon-containing (meth)acrylate-based compound is a compound having one or more acryloyl groups or methacryloyl groups. Examples of a silicon-containing monofunctional (meth)acrylate-based compound having one acryloyl group or methacryloyl group are as follows, but the compound is not limited to these examples.
(2-acryloylethoxy)trimethylsilane,
N-(3-acryloyl-2-hydroxypropyl)-3-aminopropyltriethoxysilane,
acryloxymethyltrimethoxysilane,
(acryloxymethyl)phenethyltrimethoxysilane,
acryloxymethyltrimethylsilane,
(3-acryloxypropyl)dimethylmethoxysilane,
(3-acryloxypropyl)methylbis(trimethylsiloxy)silane,
(3-acryloxypropyl)methyldichlorosilane,
(3-acryloxypropyl)methyldiethoxysilane,
(3-acryloxypropyl)methyldimethoxysilane,
(3-acryloxypropyl)trichlorosilane,
(3-acryloxypropyl)trimethoxysilane,
(3-acryloxypropyl)tris(trimethylsiloxy)silane,
acryloxytriisopropylsilane,
acryloxytrimethylsilane,
methacryloxymethyltrimethoxysilane,
O-(methacryloxyethoxy)carbamoylpropylmethyldimethoxysilane,
(methacryloxymethyl)bis(trimethylsiloxy)methylsilane,
N-(3-methacryloyl-2-hydroxypropyl)-3-aminopropyltriethoxysilane,
(methacryloxymethyl)methyldimethoxysilane,
(methacryloxymethyl)methyldiethoxysilane,
methacryloxymethylmethyltriethoxysilane,
methacryloxypropyltrimethoxysilane,
methacryloylpropyltriisopropoxysilane,
O-(methacryloxyethyl)-N-(triethoxysilylpropyl) carbamate,
methacryloxypropylmethyldimethoxysilane,
methacryloxypropylmethyldiethoxysilane,
methacryloxypropyldimethylmethoxysilane,
methacryloxypropyldimethylethoxysilane,
(methacryloxymethyl)dimethylethoxysilane,
methacryloxypropyltriethoxysilane,
methacryloxypropylsilatrane,
methacryloxypentamethyldisiloxane,
(methacryloxymethyl)phenyldimethylsilane,
methacryloxytrimethylsilane,
methacryloxymethyltrimethylsilane,
(3-methacryloxy-2-hydroxypropoxypropyl)methyl bis(trimethylsiloxy)silane,
methacryloxypropylpentamethyldisiloxane,
O-(methacryloxyethyl)-3-[bis(trimethylsiloxy)methylsilyl]propylcarbamate,
methacryloxymethyltris(trimethylsiloxy)silane,
methacryloxyethoxytrimethylsilane,
(3-methacryloxy-2-hydroxypropoxypropyl)methyl bis(trimethylsiloxy)silane,
methacryloxypropyltris(vinyldimethylsiloxy)silane,
methacryloxypropyltris(trimethylsiloxy)silane,
3-methacryloxypropyltriacetoxysilane,
methacryloxypropylmethyldichlorosilane,
methacryloxypropyltrichlorosilane,
3-methacryloxypropylbis(trimethylsiloxy)methylsilane,
3-methacroloxypropyldimethylchlorosilane,
O-methacryloxy(polyethyleneoxy)trimethylsilane,
poly(methacryloxypropylsilsesquioxane),
methacryloxypropylheptaisobutyl-T8-silsesquioxane, and
methacryloxypropyltris(trimethylsiloxy)silane

Examples of the commercially available products of the above-described silicon-containing monofunctional (meth)acrylic compounds are as follows, but the products are not limited to these examples.
SIA0160.0, SIA0180.0, SIA0182.0, SIA0184.0, SIA0186.0, SIA0190.0,
SIA0194.0, SIA0196.0, SIA0197.0, SIA0198.0, SIA0199.0, SIA0200.0,
SIA0200.A1, SIA0210.0, SIA0315.0, SIA0320.0, SIM6483.0, SIM6487.5,
SIM6480.76, SIM6481.2, SIM6486.1, SIM6481.1, SIM6481.46, SIM6481.43,
SIM6482.0, SIM6487.4, SIM6487.35, SIM6480.8, SIM6486.9, SIM6486.8,
SIM6486.5, SIM6486.4, SIM6481.3, SIM6487.3, SIM6487.1, SIM6487.6,
SIM6486.14, SIM6481.48, SIM6481.5, SIM6491.0, SIM6485.6, SIM6481.15,
SIM6487.0, SIM6481.05, SIM6485.8, SIM6481.0, SIM6487.4LI, SIM6481.16,
SIM6487.8, SIM6487.6HP, SIM6487.17, SIM6486.7, SIM6487.2, SIM6486.0,
SIM6486.2, SIM6487.6-06, SIM6487.6-20, SIM6485.9, SST-R8C42, SLT-3R01,
and SIM6486.65 (manufactured by GELEST), and
TM-0701T, FM-0711, FM-0721, and FM-0725 (manufactured by JNC)

A silicon-containing (meth)acrylamide-based compound is a compound having one or more acrylamide groups or methacrylamide groups. Examples of a silicon-containing monofunctional (meth)acrylamide-based compound having one acrylamide group or methacrylamide group are as follows, but the compound is not limited to these examples.
3-acrylamidopropyltrimethoxysilane, and 3-
acrylamidopropyltris(trimethylsiloxy)silane

Examples of the commercially available products of the above-described silicon-containing monofunctional (meth)acrylamide compounds are as follows, but the products are not limited to these examples.
SIA0146.0, and SIA0150.0 (manufactured by GELEST)

Examples of a polyfunctional (meth)acrylate-based compound having two or more acryloyl groups or methacryloyl groups are as follows, but the compound is not limited to these examples.
linear polydimethylsiloxane modified on both ends with acryloxypropyl groups,
linear polydimethylsiloxane modified on both ends with methacryloxypropyl groups,
cyclic siloxane modified with multiple acryloxypropyl groups,
cyclic siloxane modified with multiple methacryloxypropyl groups,
silsesquioxane modified with multiple acryloxypropyl groups, and
silsesquioxane modified with multiple methacryloxypropyl groups

Examples of the commercially available products of the above-described silicon-containing polyfunctional (meth) acrylate compounds are as follows, but the products are not limited to these examples.
SIA0200.2, SIA0200.3, SIM6487.42, DMS-R11, DMS-R05, DMS-R22, DMS-R18, DMS-R31 (manufactured by GELEST),
FM-7711, FM-7721, FM-7725 (manufactured by JNC),
X-22-2445 (manufactured by Shin-Etsu Chemical), and
AC-SQ TA-100, MAC-SQ TM-100, AC-SQ SI-20, MAC-SQ SI-20 (manufactured by TOAGOSEI)

Also, according to a known literature (for example, "Ultraviolet curable branched siloxanes as low-k dielectricsforimprint lithography"
(https;//doi.org/10.1116/1.4770051) by Ogawa et al.), it is possible to synthesize and obtain linear modified polydimethylsiloxane with methacryloxypropyl groups on both ends (MA-Si-12), 8-membered ring siloxane modified with four methacryloxypropyl groups (8-ring), and 10-membered ring siloxane modified with five methacryloxypropyl groups (10-ring).

### <Component (a): Silicon-Free Polymerizable Compound>

The component (a) contains a silicon-free polymerizable compound. In this specification, the silicon-free polymerizable compound is a compound that reacts with a polymerizing factor (for example, a radical) generated from a photopolymerization initiator (the component (b)), and forms a film made of a polymer compound by a chain reaction (polymerization reaction).

An example of the polymerizable compound as described above is a radical polymerizable compound. The polymerizable compound as the component (a) can be formed by only one type of a polymerizable compound, and can also be formed by a plurality of types (one or more types) of polymerizable compounds.

Examples of the radical polymerizable compound are an Si-free (meth)acrylic compound, an Si-free styrene-based compound, an Si-free vinyl-based compound, an Si-free allylic compound, an Si-free fumaric compound, and an Si-free maleic compound.

The Si-free (meth)acrylic compound is a compound having one or more acryloyl groups or methacryloyl groups. Examples of an Si-free monofunctional (meth)acrylic compound having one acryloyl group or methacryloyl group are as follows, but the compound is not limited to these examples. Phenoxyethyl (meth)acrylate, phenoxy-2-methylethyl (meth)acrylate, phenoxyethoxyethyl (meth)acrylate, 3-phenoxy-2-hydroxypropyl (meth)acrylate, 2-phenylphenoxyethyl (meth)acrylate, 4-phenylphenoxyethyl (meth)acrylate, 3-(2-phenylphenyl)-2-hydroxypropyl (meth)acrylate, (meth)acrylate of EO-modified p-cumylphenol, 2-bromophenoxyethyl (meth)acrylate, 2,4-dibromophenoxyethyl (meth)acrylate, 2,4,6-tribromophenoxyethyl (meth)acrylate, EO-modified phenoxy (meth)acrylate, PO-modified phenoxy (meth)acrylate, polyoxyethylenenonylphenylether (meth)acrylate, isobornyl (meth)acrylate, 1-adamantyl (meth)acrylate, 2-methyl-2-adamantyl (meth)acrylate, 2-ethyl-2-adamantyl (meth)acrylate, bornyl (meth)acrylate, tricyclodecanyl (meth)acrylate, dicyclopentanyl (meth)acrylate, dicyclopentenyl (meth)acrylate, cyclohexyl (meth)acrylate, 4-butylcyclohexyl( meth)acrylate, acryloylmorpholine, 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate, t-butyl (meth)acrylate, pentyl (meth)acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, undecyl (meth)acrylate, dodecyl (meth)acrylate, lauryl (meth)acrylate, stearyl (meth)acrylate, isostearyl (meth)acrylate, benzyl (meth)acrylate, tetrahydrofurfuryl (meth)acrylate, butoxyethyl (meth)acrylate, ethoxydiethyleneglycol (meth)acrylate, polyethyleneglycol mono(meth)acrylate, polypropyleneglycol mono(meth)acrylate, methoxyethyleneglycol (meth)acrylate, ethoxyethyl (meth)acrylate, methoxypolyethyleneglycol (meth)acrylate, methoxypolypropyleneglycol (meth)acrylate, diacetone (meth)acrylamide, isobutoxymethyl (meth)acrylamide, N,N-dimethyl (meth)acrylamide, t-octyl (meth)acrylamide, dimethylaminoethyl (meth)acrylate, diethylaminoethyl (meth)acrylate, 7-amino-3,7-dimethyloctyl (meth)acrylate, N,N-diethyl (meth)acrylamide, N,N-dimethylaminopropyl (meth)acrylamide, 1- or 2-naphthyl (meth)acrylate, 1- or 2-naphthylmethyl (meth)acrylate, 3- or 4-phenoxybenzyl (meth)acrylate, and cyanobenzyl (meth)acrylate.

Examples of the commercially available products of the above-described Si-free monofunctional (meth)acrylic compounds are as follows, but the products are not limited to these examples.
ARONIX^{®} M101, M102, M110, M111, M113, M117, M5700, TO-1317, M120, M150, and M156 (manufactured by TOAGOSEI)
MEDOL10, MIBDOL10, CHDOL10, MMDOL30, MEDOL30, MIBDOL30, CHDOL30, LA, IBXA, 2-MTA, HPA, and Viscoat #150, #155, #158, #190, #192, #193, #220, #2000, #2100, and #2150 (manufactured by OSAKA ORGANIC CHEMICAL INDUSTRY)
Light Acrylate BO-A, EC-A, DMP-A, THF-A, HOP-A, HOA-MPE, HOA-MPL, PO-A, P-200A, NP-4EA, NP-8EA, Epoxy Ester M-600A, POB-A, and OPP-EA (manufactured by KYOEISHA CHEMICAL)
KAYARAD^{®} TC110S, R-564, and R-128H (manufactured by NIPPON KAYAKU)
NK Ester AMP-10G, AMP-20G, and A-LEN-10 (manufactured by SHIN-NAKAMURA CHEMICAL)
FA-511A, 512A, and 513A (manufactured by Hitachi Chemical)
PHE, CEA, PHE-2, PHE-4, BR-31, BR-31M, and BR-32 (manufactured by DKS) VP (manufactured by BASF)
and ACMO, DMAA, and DMAPAA (manufactured by Kohjin).

Examples of a silicon-free polyfunctional (meth)acrylic compound having two or more acryloyl groups or methacryloyl groups are as follows, but the compound is not limited to these examples.
Trimethylolpropane di(meth)acrylate, trimethylolpropane tri(meth)acrylate, EO-modified trimethylolpropane tri(meth)acrylate, PO-modified trimethylolpropane tri(meth)acrylate, EO- and PO-modified trimethylolpropane tri(meth)acrylate, dimethylol tricyclodecane di(meth)acrylate, pentaerythritol tri(meth)acrylate, pentaerythritol tetra(meth)acrylate, ethylene glycol di(meth)acrylate, tetraethylene glycol di(meth)acrylate, polyethylene glycol di(meth)acrylate, polypropylene glycol di(meth)acrylate, 1,4-butanediol di(meth)acrylate, 1,6-hexanediol di(meth)acrylate, neopentyl glycol di(meth)acrylate, 1,9-nonanediol di(meth)acrylate, 1,10-decanediol di(meth)acrylate, 1,3-adamantanedimethanol di(meth)acrylate, tris(2-hydoxyethyl)isocyanurate tri(meth)acrylate, tris(acryloyloxy)isocyanurate, bis(hydroxymethyl)tricyclodecane di(meth)acrylate, dipentaerythritol penta(meth)acrylate, dipentaerythritol hexa(meth)acrylate, EO-modified 2,2-bis(4-((meth)acryloxy)phenyl)propane, PO-modified 2,2-bis(4-((meth)acryloxy)phenyl)propane, EO- and PO-modified 2,2-bis(4-((meth)acryloxy)phenyl)propane, o-, m-, or p-benzene di(meth)acrylate, and o-, m-, or p-xylylene di(meth)acrylate.

Examples of the commercially available products of the above-described Si-free polyfunctional (meth)acrylic compounds are as follows, but the products are not limited to these examples.
Yupimer^{®} UV SA1002 and SA2007 (manufactured by Mitsubishi Chemical)
Viscoat #195, #230, #215, #260, #335HP, #295, #300, #360, #700, GPT, and 3PA (manufactured by OSAKA ORGANIC CHEMICAL INDUSTRY)
Light Acrylate 4EG-A, 9EG-A, NP-A, DCP-A, BP-4EA, BP-4PA, TMP-A, PE-3A, PE-4A, and DPE-6A (manufactured by KYOEISHA CHEMICAL)
KAYARAD^{®} PET-30, TMPTA, R-604, DPHA, DPCA-20, -30, -60, and -120, HX-620, D-310, and D-330 (manufactured by NIPPON KAYAKU)
ARONIX^{®} M208, M210, M215, M220, M240, M305, M309, M310, M315, M325, and M400 (manufactured by TOAGOSEI)
Ripoxy^{®} VR-77, VR-60, and VR-90 (manufactured by Showa Highpolymer)
OGSOL EA-0200 and OGSOL EA-0300 (manufactured by Osaka Gas Chemicals).

Note that in the above-described compounds, (meth)acrylate means acrylate or methacrylate having an alcohol residue equal to acrylate. A (meth)acryloyl group means an acryloyl group or a methacryloyl group having an alcohol residue equal to the acryloyl group. EO indicates ethylene oxide, and an EO-modified compound A indicates a compound in which a (meth)acrylic acid residue and an alcohol residue of a compound A bond via the block structure of an ethylene oxide group. Also, PO indicates a propylene oxide, and a PO-modified compound B indicates a compound in which a (meth)acrylic acid residue and an alcohol residue of a compound B bond via the block structure of a propylene oxide group.

Practical examples of the Si-free styrene-based compound are as follows, but the compound is not limited to these examples.
Alkylstyrene such as styrene, 2,4-dimethyl-α-methylstyrene, o-methylstyrene, m-methylstyrene, p-methylstyrene, 2,4-dimethylstyrene, 2,5-dimethylstyrene, 2,6-dimethylstyrene, 3,4-dimethylstyrene, 3,5-dimethylstyrene, 2,4,6-trimethylstyrene, 2,4,5-trimethylstyrene, pentamethylstyrene, o-ethylstyrene, methylstyrene, p-ethylstyrene, diethylstyrene, triethylstyrene, propylstyrene 2,4-diisopropylstyrene, butylstyrene, hexylstyrene, heptylstyrene, and octylstyrene; styrene halide such as fluorostyrene, o-chlorostyrene, m-chlorostyrene, p-chlorostyrene, o-bromostyrene, m-bromostyrene, p-bromostyrene, dibromostyrene, and iodostyrene; and a compound having a styryl group as a polymerizable functional group, such as nitrostyrene, acetylstyrene, o-methoxystyrene, m-methoxystyrene, p-methoxystyrene, o-hydroxystyrene, m-hydroxystyrene, p-hydroxystyrene, 2-vinylbiphenyl, 3-vinylbiphenyl, 4-vinylbiphenyl, 1-vinylnaphthalene, 2-vinylnaphthalene, 4-vinyl-p-terphenyl, 1-vinylanthracene, α-methylstyrene, o-isopropenyltoluene, m-isopropenyltoluene, p-isopropenyltoluene, 2,3-dimethyl-α-methylstyrene, 3,5-dimethyl-α-methylstyrene, p-isopropyl-α-methylstyrene, α-ethylstyrene, α-chlorostyrene, divinylbenzene, diisopropylbenzene, and divinylbiphenyl.

Practical examples of the Si-free vinyl-based compound are as follows, but the compound is not limited to these examples.
Vinylpyridine, vinylpyrrolidone, vinylcarbazole, vinyl acetate, and acrylonitrile; conjugated diene monomers such as butadiene, isoprene, and chloroprene; vinyl halide such as vinyl chloride and vinyl bromide; a compound having a vinyl group as a polymerizable functional group, for example, vinylidene halide such as vinylidene chloride, vinyl ester of organic carboxylic acid and its derivative (for example, vinyl acetate, vinyl propionate, vinyl butyrate, vinyl benzoate, and divinyl adipate), and (meth)acrylonitrile.
Note that in this specification, (meth)acrylonitrile is a general term for acrylonitrile and methacrylonitrile.

Examples of the Si-free allylic compound are as follows, but the compound is not limited to these examples.
Allyl acetate, allyl benzoate, diallyl adipate, diallyl terephthalate, diallyl isophthalate, and diallyl phthalate.

Examples of the Si-free fumaric compound are as follows, but the compound is not limited to these examples.
Dimethyl fumarate, diethyl fumarate, diisopropyl fumarate, di-sec-butyl fumarate, diisobutyl fumarate, di-n-butyl fumarate, di-2-ethylhexyl fumarate, and dibenzyl fumarate.

Examples of the Si-free maleic compound are as follows, but the compound is not limited to these examples.
Dimethyl maleate, diethyl maleate, diisopropyl maleate, di-sec-butyl maleate, diisobutyl maleate, di-n-butyl maleate, di-2-ethylhexyl maleate, and dibenzyl maleate.

Other examples of the Si-free radical polymerizable compound are as follows, but the compound is not limited to these examples.
Dialkylester of itaconic acid and its derivative (for example, dimethyl itaconate, diethyl itaconate, diisopropyl itaconate, di-sec-butyl itaconate, diisobutyl itaconate, di-n-butyl itaconate, di-2-ethylhexyl itaconate, and dibenzyl itaconate), an N-vinylamide derivative of organic carboxylic acid (for example, N-methyl-N-vinylacetamide), and maleimide and its derivative (for example, N-phenylmaleimide and N-cyclohexylmaleimide).

If the component (a) is formed by a plurality of types of compounds having one or more polymerizable functional groups, a monofunctional compound and a polyfunctional compound are preferably included. This is because if a monofunctional compound and a polyfunctional compound are combined, a cured film having well-balanced performance, for example, a high mechanical strength, a high dry etching resistance, and a high heat resistance can be obtained.

The film forming method according to the embodiment may require a few milliseconds to a few hundreds of seconds until droplets of the curable composition (A) discretely arranged on a substrate combine with each other and form a practically continuous liquid film, so a waiting step (to be described later) is necessary. In this waiting step, the solvent (d) is volatilized, but the polymerizable compound (a) is not volatilized. Hence, in the polymerizable compound (a) that can contain a plurality of types of compounds, the boiling points of all the compounds at normal pressure are preferably 250°C or more, more preferably 300°C or more, and further preferably 350°C or more. Also, to obtain a high dry etching resistance and a high heat resistance, the cured film of the curable composition (A) preferably contains at least a compound having a cyclic structure such as an aromatic structure, an aromatic heterocyclic structure, or an alicyclic structure.

The boiling point of the polymerizable compound (a) is almost correlated with the molecular weight. Therefore, the molecular weights of all the polymerizable compounds (a) are preferably 200 or more, more preferably 240 or more, and further preferably 250 or more. However, even when the molecular weight is 200 or less, the compound is preferably usable as the polymerizable compound (a) of the present invention if the boiling point is 250°C or more.

In addition, the vapor pressure at 80°C of the polymerizable compound (a) is preferably 0.001 mmHg or less. This is so because, although it is favorable to heat the curable composition when accelerating volatilization of the solvent (d) (to be described later), it is necessary to suppress volatilization of the polymerizable compound (a) during heating.

Note that the boiling point and the vapor pressure of each organic compound at normal pressure can be calculated by, for example, Hansen Solubility Parameters in Practice (HSPiP) 5th Edition. 5.3.04.

Practical examples of the polymerizable compound (component (a) having a boiling point of 250°C or more are, for example, as follows, but the compound is not limited to these examples.
dicyclopentanyl acrylate (boiling point = 262°C, molecular weight = 206) dicyclopentenyl acrylate (boiling point = 270°C, molecular weight = 204)
1,3-cyclohexanedimethanol diacrylate (boiling point = 310°C, molecular weight = 252)
1,4-cyclohexanedimethanol diacrylate (boiling point = 339°C, molecular weight = 252)
4-hexylresorcinol diacrylate (boiling point = 379°C, molecular weight = 302)
6-phenylhexane-1,2-diol diacrylate (boiling point = 381°C, molecular weight = 302)
7-phenylheptan-1,2-diol diacrylate (boiling point = 393°C, molecular weight = 316)
1,3-bis((2-hydroxyethoxy)methyl)cyclohexane diacrylate (boiling point = 403°C, molecular weight = 340)
8-phenyloctane-1,2-diol diacrylate (boiling point = 404°C, molecular weight = 330)
1,3-bis((2-hydroxyethoxy)methyl)benzene diacrylate (boiling point = 408°C, molecular weight = 334)
1,4-bis((2-hydroxyethoxy)methyl)cyclohexane diacrylate (boiling point = 445°C, molecular weight = 340)
3-phenoxybenzyl acrylate (mPhOBzA, OP = 2.54, boiling point = 367.4°C, 80°C vapor pressure = 0.0004 mmHg, molecular weight = 254.3)

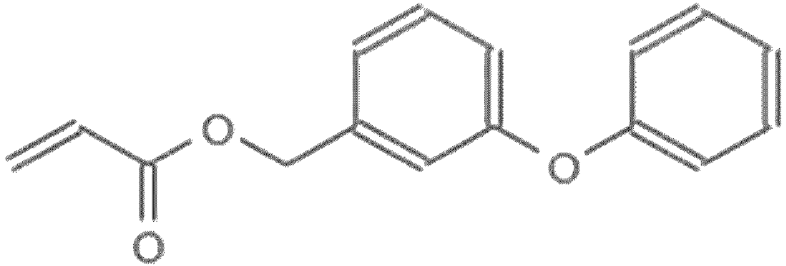

1-naphthyl acrylate (NaA, OP = 2.27, boiling point = 317°C, 80°C vapor pressure = 0.0422 mmHg, molecular weight = 198)

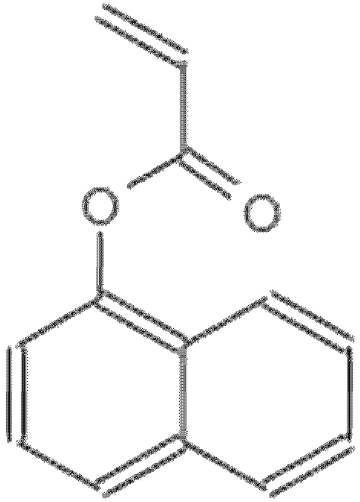

2-phenylphenoxyethyl acrylate (PhPhOEA, OP = 2.57, boiling point = 364.2°C, 80°C vapor pressure = 0.0006 mmHg, molecular weight = 268.3)

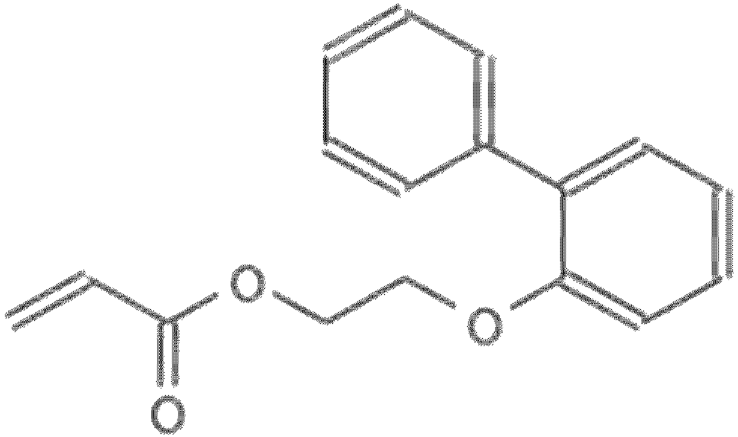

1-naphthylmethyl acrylate (Na1MA, OP = 2.33, boiling point = 342.1°C, 80°C vapor pressure = 0.042 mmHg, molecular weight = 212.2)

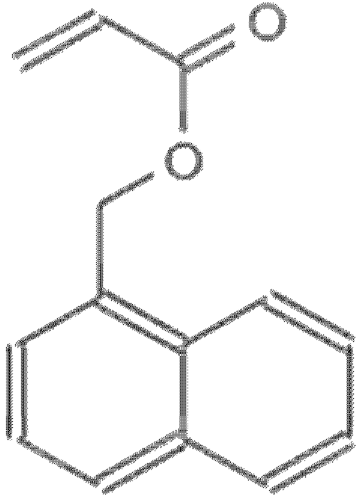

2-naphthylmethyl acrylate (Na2MA, OP = 2.33, boiling point = 342.1°C, 80°C vapor pressure = 0.042 mmHg, molecular weight = 212.2)

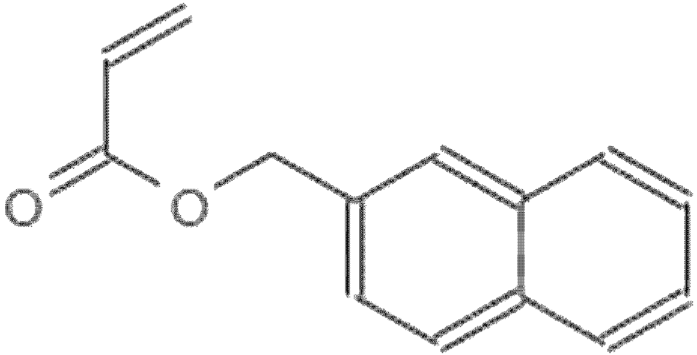

4-cyanobenzyl acrylate (CNBzA, OP = 2.44, boiling point = 316°C, molecular weight = 187)

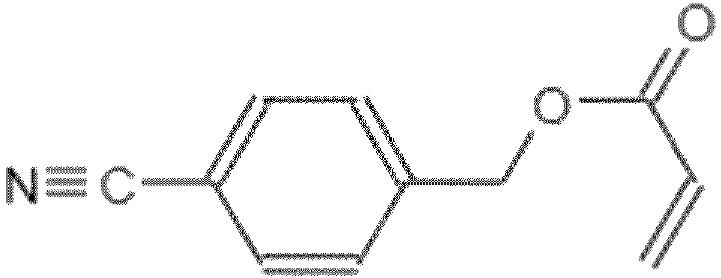

DVBzA indicated by the formula below (OP = 2.50, boiling point = 304.6°C, 80°C vapor pressure = 0.0848 mmHg, molecular weight = 214.3)

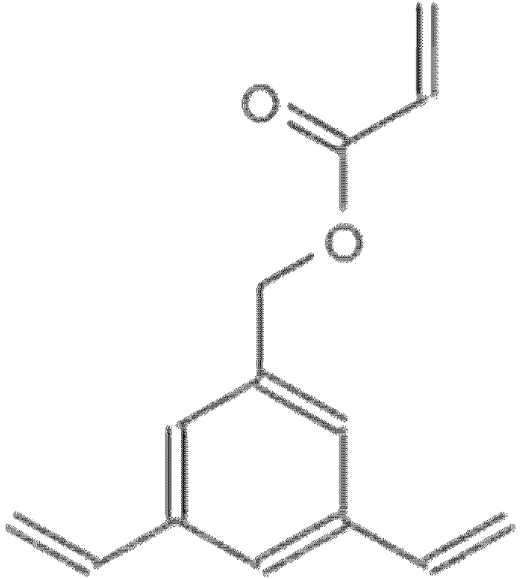

DPhPA indicated by the formula below (OP = 2.38, boiling point = 354.5°C, 80°C vapor pressure = 0.0022 mmHg, molecular weight = 266.3)

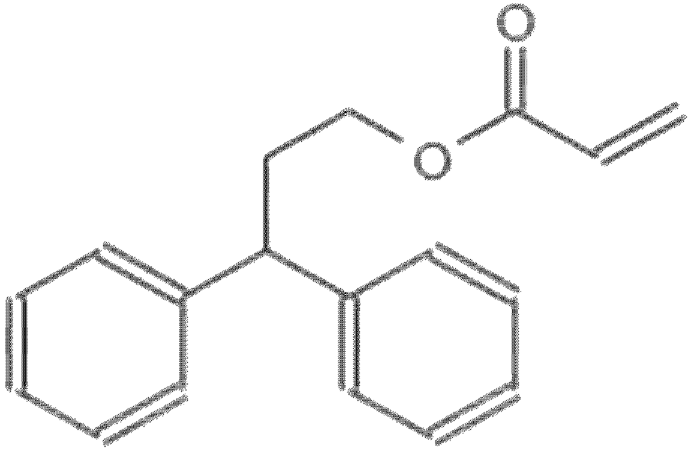

PhBzA indicated by the formula below (OP = 2.29, boiling point = 350.4°C, 80°C vapor pressure = 0.0022 mmHg, molecular weight = 238.3)

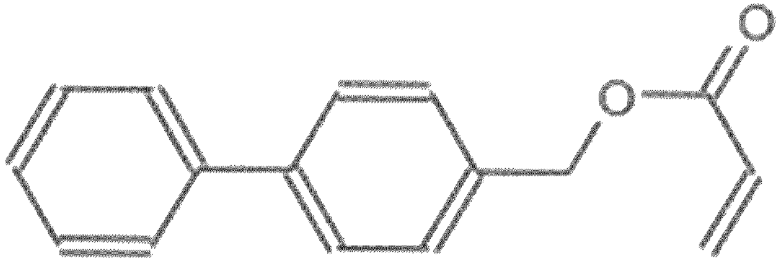

FLMA indicated by the formula below (OP = 2.20, boiling point = 349.3°C, 80°C vapor pressure = 0.0018 mmHg, molecular weight = 250.3)

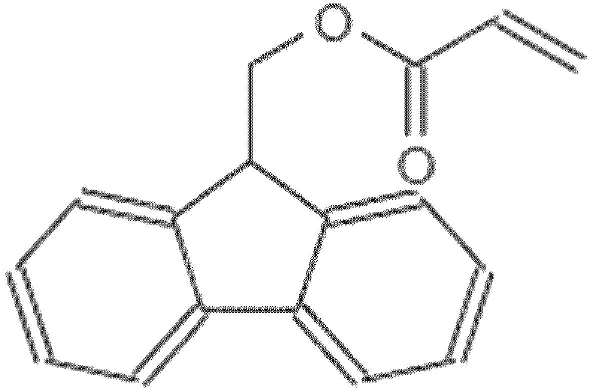

ATMA indicated by the formula below (OP = 2.13, boiling point = 414.9°C, 80°C vapor pressure = 0.0001 mmHg, molecular weight = 262.3)

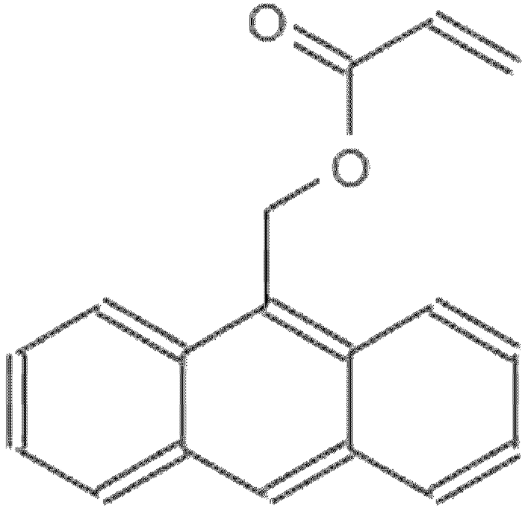

DNaMA indicated by the formula below (OP = 2.00, boiling point = 489.4°C, 80°C vapor pressure < 0.0001 mmHg, molecular weight = 338.4)

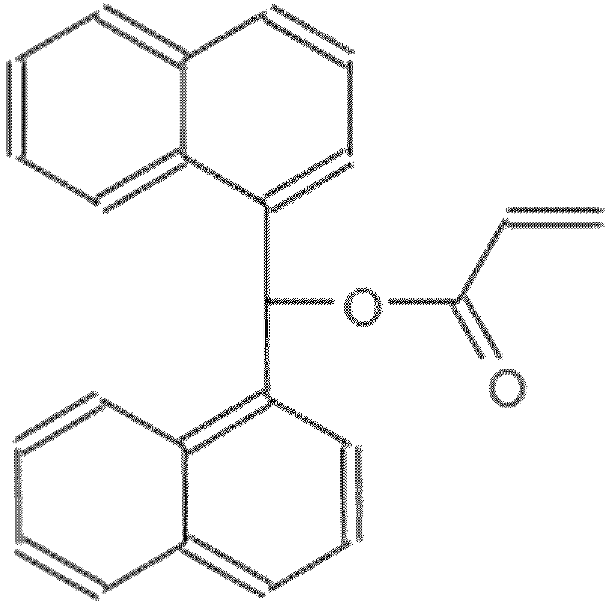

tricyclodecanedimethanol diacrylate (DCPDA, OP = 3.29, boiling point = 342°C, 80°C vapor pressure < 0.0024 mmHg, molecular weight = 304)

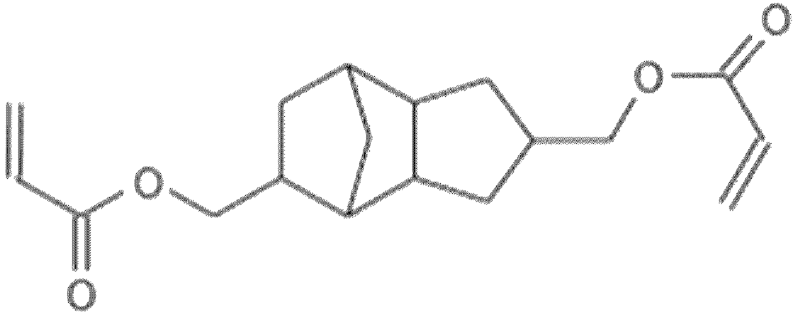

m-xylylene diacrylate (mXDA, OP = 3.20, boiling point = 336°C, 80°C vapor pressure < 0.0043 mmHg, molecular weight = 246)

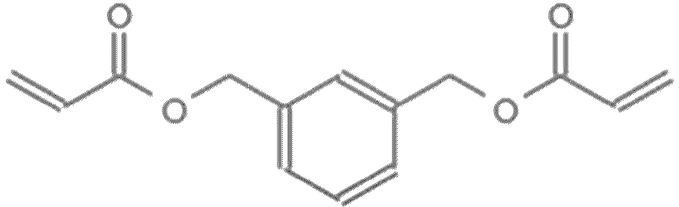

1-phenylethane-1,2-diyl diacrylate (PhEDA, OP = 3.20, 80°C vapor pressure < 0.0057 mmHg, boiling point = 354°C, molecular weight = 246)

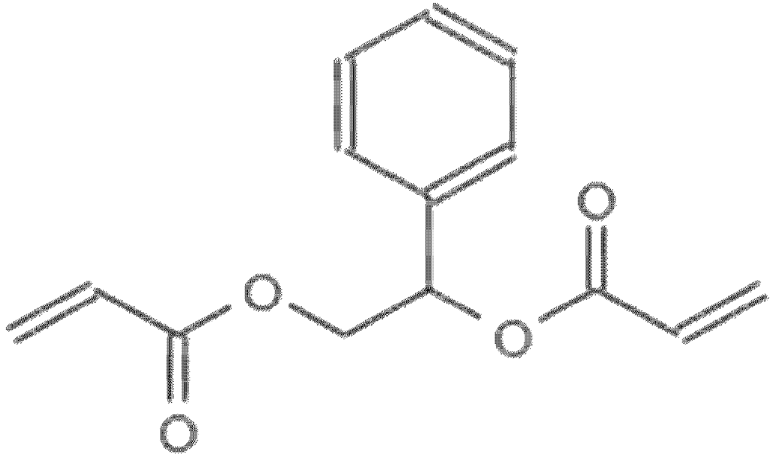

2-phenyl-1,3-propanediol diacrylate (PhPDA, OP = 3.18, boiling point = 340°C, 80°C vapor pressure < 0.0017 mmHg, molecular weight = 260)

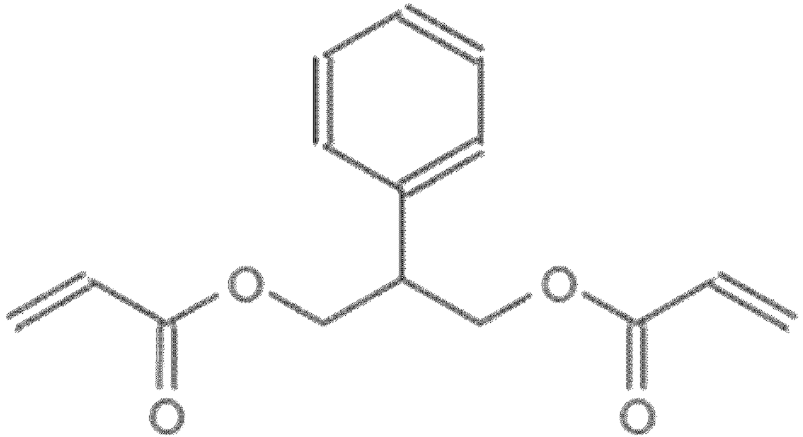

VmXDA indicated by the formula below (OP = 3.00, boiling point = 372.4°C, 80°C vapor pressure = 0.0005 mmHg, molecular weight = 272.3)

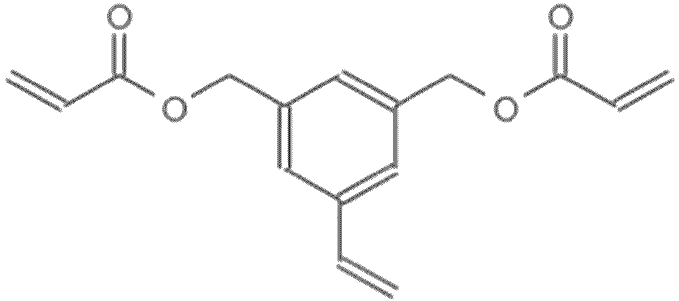

BPh44DA indicated by the formula below (OP = 2.63, boiling point = 444°C, 80°C vapor pressure < 0.0001 mmHg, molecular weight = 322.3)

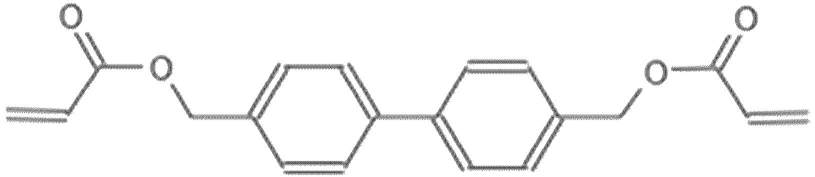

BPh43DA indicated by the formula below (OP = 2.63, boiling point = 439.5°C, 80°C vapor pressure < 0.0001 mmHg, molecular weight = 322.3)

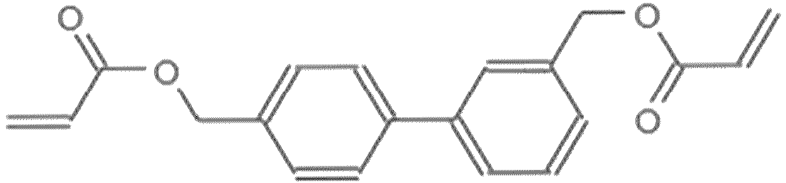

DPhEDA indicated by the formula below (OP = 2.63, boiling point = 410°C, 80°C vapor pressure < 0.0001 mmHg, molecular weight = 322.3)

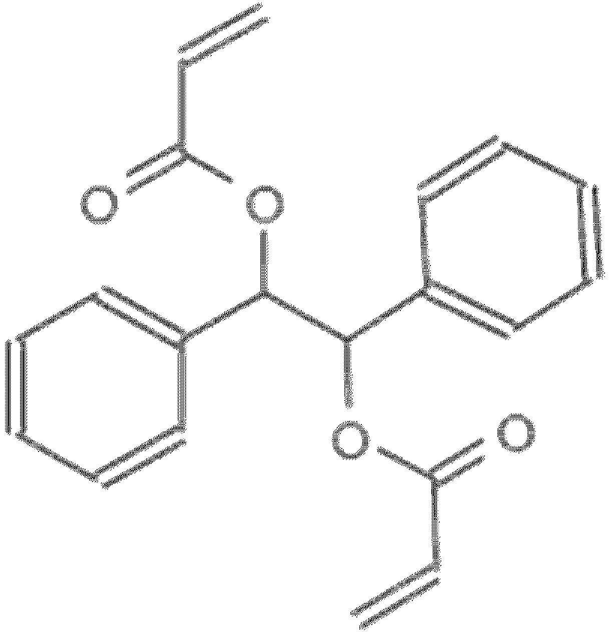

BPMDA indicated by the formula below (OP = 2.68, boiling point = 465.7°C, 80°C vapor pressure < 0.0001 mmHg, molecular weight = 364.4)

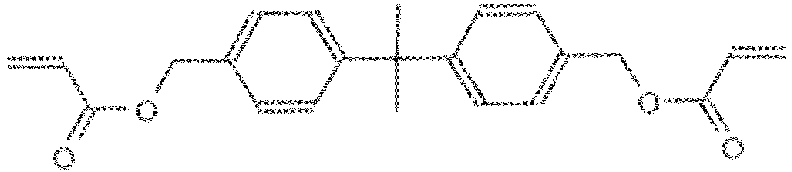

Na13MDA indicated by the formula below (OP = 2.71, boiling point = 438.8°C, 80°C vapor pressure < 0.0001 mmHg, molecular weight = 296.3)

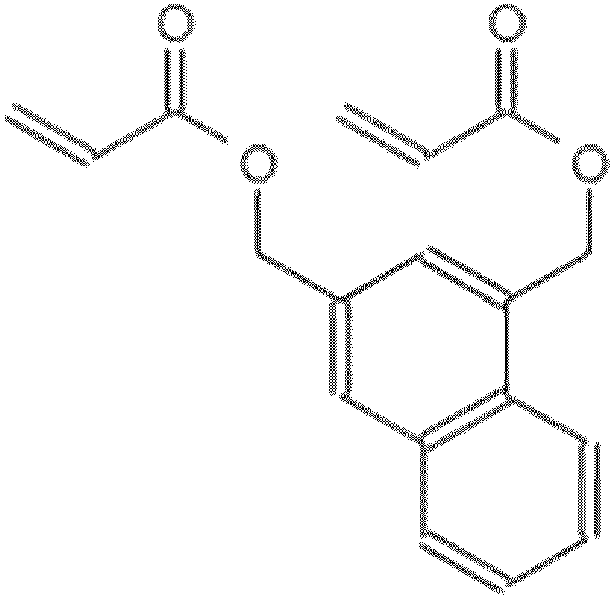

The blending ratio of the component (as) in the curable composition (A) is preferably 40 wt% or more and 99 wt% or less with respect to the combination of the component (as) and the component (a), a component (b) (to be described later), and a component (c) (to be described later), that is, the total mass of all the components except the solvent (d). The blending ratio is more preferably 50 wt% or more and 95 wt% or less, and further preferably 60 wt% or more and 90 wt% or less. When the blending ratio of the component (as) is 40 wt% or more, the mechanical strength of the cured film of the curable composition increases. Also, when the blending ratio of the component (as) is 99 wt% or less, it is possible to increase the blending ratios of the components (b) and (c), and obtain characteristics such as a high photopolymerization rate.

At least a part of the component (a) which may include a plurality of types of additive components can be polymers having a polymerizable functional group. The polymer preferably contains at least a cyclic structure such as an aromatic structure, an aromatic heterocyclic structure, or an alicyclic structure. For example, the polymer preferably contains at least one of constituent units represented by formulas (3) to (8) below:

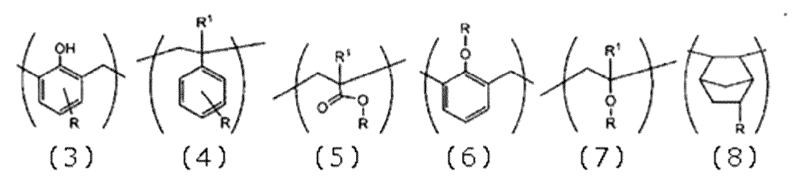

In the formulas (3) to (8), a substituent group R is a substituent group containing partial structures each independently containing an aromatic ring, and R¹ is a hydrogen atom or a methyl group. In this specification, in constituent units represented by the formulas (3) to (8), a portion other than R is the main chain of a specific polymer. The formula weight of the substituent group R is 80 or more, preferably 100 or more, more preferably 130 or more, and further preferably 150 or more. The upper limit of the formula weight of the substituent group R is practically 500 or less.

A polymer having a polymerizable functional group is normally a compound having a weight-average molecular weight of 500 or more. The weight-average molecular weight is preferably 1,000 or more, and more preferably 2,000 or more. The upper limit of the weight-average molecular weight is not particularly determined, but is preferably, for example, 50,000 or less. When the weight-average molecular weight is set at the above-described lower limit or more, it is possible to set the boiling point at 250°C or more, and further improve the mechanical properties after curing. Also, when the weight-average molecular weight is set at the above-described upper limit or less, the solubility to the solvent increases, and the flowability of discretely arranged droplets is maintained because the viscosity is not too high. This makes it possible to further improve the flatness of the liquid film surface. Note that the weight-average molecular weight (Mw) in the present invention is a molecular weight measured by gel permeation chromatography (GPC), unless it is specifically stated otherwise.

Practical examples of the polymerizable functional group of the polymer are a (meth)acryloyl group, an epoxy group, an oxetane group, a methylol group, a methylol ether group, and a vinyl ether group. A (meth)acryloyl group is particularly favorable from the viewpoint of polymerization easiness.

When adding the polymer having the polymerizable functional group as at least a part of the component (a), the blending ratio can freely be set as long as the blending ratio falls within the range of the viscosity regulation to be described later. For example, the blending ratio of polymer to the total mass of all the components except for the solvent (d) is preferably 0.1 wt% or more and 60 wt% or less, more preferably 1 wt% or more and 50 wt% or less, and further preferably 10 wt% or more and 40 wt% or less. When the blending ratio of the polymer having the polymerizable functional group is set at 0.1 wt% or more, it is possible to improve the heat resistance, the dry etching resistance, the mechanical strength, and the low volatility. Also, when the blending ratio of the polymer having the polymerizable functional group is set at 60 wt% or less, it is possible to make the blending ratio fall within the range of the upper limit regulation of the viscosity (to be described later).

### <Component (b): Photopolymerization Initiator>

The component (b) is a photopolymerization initiator. In this specification, the photopolymerization initiator is a compound that senses light having a predetermined wavelength and generates a polymerizing factor (radical) described earlier. More specifically, the photopolymerization initiator is a polymerization initiator (radical generator) that generates a radical by light (infrared light, visible light, ultraviolet light, far-ultraviolet light, X-ray, a charged particle beam such as an electron beam, or radiation). The component (b) can be formed by only one type of a photopolymerization initiator, and can also be formed by a plurality of types of photopolymerization initiators.

Examples of the radical generator are as follows, but the radical generator is not limited to these examples.
2,4,5-triarylimidazole dimers that can have substituent groups, such as a 2-(o-chlorophenyl)-4,5-diphenylimidazole dimer, a 2-(o-chlorophenyl)-4,5-di(methoxyphenyl)imidazole dimer, a 2-(o-fluorophenyl)-4,5-diphenylimidazole dimer, and a 2-(o- or p-methoxyphenyl)-4,5-diphenylimidazole dimer; benzophenone derivatives such as benzophenone, N,N'-tetramethyl-4,4'-diaminobenzophenone (Michiler's ketone), N,N'-tetraethyl-4,4'-diaminobenzophenone, 4-methoxy-4'-dimethylaminobenzophenone, 4-chlorobenzophenone, 4,4'-dimethoxybenzophenone, and 4,4'-diaminobenzophenone; α-amino aromatic ketone derivatives such as 2-benzyl-2-dimethylamino-1-(4-morpholinophenyl)-butanone-1,2-methyl-1-[4-(methylthio)phenyl]-2-morpholino-propane-1-one; quinones such as 2-ethyl anthraquinone, phenanthrenequinone, 2-t-butylanthraquinone, octamethylanthraquinone, 1,2-benzanthraquinone, 2,3-benzanthraquinone, 2-phenylanthraquinone, 2,3-diphenylamthraquinone, 1-chloroanthraquinone, 2-methylanthraquinone, 1,4-naphtoquinone, 9,10-phenanthraquinone, 2-methyl-1,4-naphtoquinone, and 2,3-dimethylanthraquinone; benzoin ether derivatives such as benzoin methyl ether, benzoin ethyl ether, and benzoin phenyl ether; benzoin derivatives such as benzoin, methyl benzoin, ethyl benzoin, and propyl benzoin; benzyl derivatives such as benzyldimethylketal; acridine derivatives such as 9-phenylacridine and 1,7-bis(9,9'-acrydinyl)heptane; N-phenylglycine derivatives such as N-phenylglycine; acetophenone derivatives such as acetophenone, 3-methylacetophenone, acetophenone benzylketal, 1-hydroxycylohexyl phenylketone, and 2,2-dimethoxy-2-phenyl acetophenone; thioxanthone derivatives such as thioxanthone, diethylthioxanthone, 2-isopropylthioxanthone, and 2-chlorothioxanthone; acylphosphine oxide derivatives such as 2,4,6-trimethylbenzoyldiphenylphosphine oxide, bis(2,4,6-trimethylbenzoyl)phenylphosphine oxide, and bis-(2,6-dimethoxybenzoyl)-2,4,4-trimethylpentylphosphine oxide; oxime ester derivatives such as 1,2-octanedione, 1-[4-(phenylthiol)-,2-(O-benzoyloxime)], ethanone, 1-[9-ethyl-6-(2-methylbenzoyl)-9H-carbazole-3-yl]-, and 1-(O-acetyloxime); and xanthone, fluorenone, benzaldehyde, fluorene, anthraquinone, triphenylamine, carbazole, 1-(4-isopropylphenyl)-2-hydroxy-2-methylprapane-1-one, and 2-hydroxy-2-methyl-1-phenylpropane-1-one.

Examples of the commercially available products of the above-described radical generators are as follows, but the products are not limited to these examples.
Irgacure 184, 369, 651, 500, 819, 907, 784, and 2959, CGI-1700, -1750, and - 1850, CG24-61, Darocur 1116 and 1173, Lucirin^{®} TPO, LR8893, and LR8970 (manufactured by BASF), and Ubecryl P36 (manufactured by UCB).

Of the above-described radical generators, the component (b) is preferably an acylphosphine oxide-based polymerization initiator. Note that of the above-described radical generators, the acylphosphine oxide-based polymerization initiators are as follows.
Acylphosphine oxide compounds such as 2,4,6-trimethylbenzoyl diphenylphosphine oxide, bis(2,4,6-trimethylbenzoyl)phenylphosphine oxide, and bis(2,6-dimethoxybenzoyl)-2,4,4-trimethylpentylphosphine oxide.

The blending ratio of the component (b) in the curable composition (A) is preferably 0.1 wt% or more and 50 wt% or less with respect to the sum of the component (a), the component (b), and a component (c) (to be described later), that is, the total mass of all the components except for the solvent (d). Also, the blending ratio of the component (b) in the curable composition (A) is more preferably 0.1 wt% or more and 20 wt% or less, and further preferably 1 wt% or more and 20 wt% or less with respect to the total mass of all the components except for the solvent (d). When the blending ratio of the component (b) is set at 0.1 wt% or more, the curing rate of the composition increases, so the reaction efficiency can be improved. Also, when the blending ratio of the component (b) is set at 50 wt% or less, a cured film having mechanical strength to some extent can be obtained.

### <Component (c): Nonpolymerizable Compound>

In addition to the components (a) and (b) described above, the curable composition (A) can further contain a nonpolymerizable compound as the component (c). An example of the component (c) is a compound that does not contain a polymerizable functional group such as a (meth)acryloyl group, and does not have the ability to sense light having a predetermined wavelength and generate the polymerizing factor (radical) described previously. Examples of the nonpolymerizable compound are a sensitizer, a hydrogen donor, an internal mold release agent, an antioxidant, a polymer component, and other additives. The component (c) can contain a plurality of types of the above-described compounds.

The sensitizer is a compound that is properly added for the purpose of promoting the polymerization reaction and improving the reaction conversion rate. As the sensitizer, it is possible to use one type of a compound alone, or to use two or more types of compounds by mixing them.

An example of the sensitizer is a sensitizing dye. The sensitizing dye is a compound that is excited by absorbing light having a specific wavelength and has an interaction with a photopolymerization initiator as the component (b). The "interaction" herein mentioned is energy transfer or electron transfer from the sensitizing dye in the excited state to the photopolymerization initiator as the component (b). Practical examples of the sensitizing dye are as follows, but the sensitizing dye is not limited to these examples.
An anthracene derivative, an anthraquinone derivative, a pyrene derivative, a perylene derivative, a carbazole derivative, a benzophenone derivative, a thioxanthone derivative, a xanthone derivative, a coumarin derivative, a phenothiazine derivative, a camphorquinone derivative, an acridinic dye, a thiopyrylium salt-based dye, a merocyanine-based dye, a quinoline-based dye, a styryl quinoline-based dye, a ketocoumarin-based dye, a thioxanthene-based dye, a xanthene-based dye, an oxonol-based dye, a cyanine-based dye, a rhodamine-based dye, and a pyrylium salt-based dye.

The hydrogen donor is a compound that reacts with an initiation radical generated from the photopolymerization initiator as the component (b) or a radical at a polymerization growth end, and generates a radical having higher reactivity. The hydrogen donor is preferably added when the photopolymerization initiator as the component (b) is a photo-radical generator.

Practical examples of the hydrogen donor as described above are as follows, but the hydrogen donor is not limited to these examples. amine compounds such as n-butylamine, di-n-butylamine, tri-n-butylphosphine, allylthiourea, s-benzylisothiuronium-p-toluenesulfinate, triethylamine, diethylaminoethyl methacrylate, triethylenetetramine, 4,4'-bis(dialkylamino)benzophenone, N,N-dimethylamino ethylester benzoate, N,N-dimethylamino isoamylester benzoate, pentyl-4-dimethylamino benzoate, triethanolamine, and N-phenylglycine; and mercapto compounds such as 2-mercapto-N-phenylbenzoimidazole and mercapto propionate ester.

It is possible to use one type of a hydrogen donor alone, or to use two or more types of hydrogen donors by mixing them. The hydrogen donor can also have a function as a sensitizer.

An internal mold release agent can be added to the curable composition for the purpose of reducing the interface bonding force between a mold and the curable composition, that is, reducing the mold release force in a mold release step (to be described later). In this specification, "internal" means that the mold release agent is added to the curable composition in advance before a curable composition arranging step. As the internal mold release agent, it is possible to use surfactants such as a silicon-based surfactant, a fluorine-based surfactant, and a hydrocarbon-based surfactant. In the present invention, however, the addition amount of the fluorine-based surfactant is limited as will be described later. Note that the internal mold release agent according to the present invention is not polymerizable. It is possible to use one type of an internal mold release agent alone, or to use two or more types of internal mold release agents by mixing them.

The fluorine-based surfactant includes the following.
A polyalkylene oxide (for example, polyethylene oxide or polypropylene oxide) adduct of alcohol having a perfluoroalkyl group, and a polyalkylene oxide (for example, polyethylene oxide or polypropylene oxide) adduct of perfluoropolyether.

Note that the fluorine-based surfactant can have a hydroxyl group, an alkoxy group, an alkyl group, an amino group, or a thiol group in a portion (for example, a terminal group) of the molecular structure. An example is pentadecaethyleneglycol mono1H,1H,2H,2H-perfluorooctylether.

It is also possible to use a commercially available product as the fluorine-based surfactant. Examples of the commercially available product of the fluorine-based surfactant are as follows.
MEGAFACE^{®} F-444, TF-2066, TF-2067, and TF-2068, and DEO-15 (abbreviation) (manufactured by DIC)
Fluorad FC-430 and FC-431 (manufactured by Sumitomo 3M)
Surflon^{®} S-382 (manufactured by AGC); EFTOP EF-122A, 122B, 122C, EF-121, EF-126, EF-127, and MF-100 (manufactured by Tochem Products)
PF-636, PF-6320, PF-656, and PF-6520 (manufactured by OMNOVA Solutions)
UNIDYNE^{®} DS-401, DS-403, and DS-451 (manufactured by DAIKIN)
FUTAGENT^{®} 250, 251, 222F, and 208G (manufactured by NEOS).

The internal mold release agent can also be a hydrocarbon-based surfactant. The hydrocarbon-based surfactant includes an alkyl alcohol polyalkylene oxide adduct obtained by adding alkylene oxide having a carbon number of 2 to 4 to alkyl alcohol having a carbon number of 1 to 50, and polyalkylene oxide.

Examples of the alkyl alcohol polyalkylene oxide adduct are as follows. A methyl alcohol ethylene oxide adduct, a decyl alcohol ethylene oxide adduct, a lauryl alcohol ethylene oxide adduct, a cetyl alcohol ethylene oxide adduct, a stearyl alcohol ethylene oxide adduct, and a stearyl alcohol ethylene oxide/propylene oxide adduct.

Note that the terminal group of the alkyl alcohol polyalkylene oxide adduct is not limited to a hydroxyl group that can be manufactured by simply adding polyalkylene oxide to alkyl alcohol. This hydroxyl group can also be substituted by a polar functional group such as a carboxyl group, an amino group, a pyridyl group, a thiol group, or a silanol group, or by a hydrophobic group such as an alkyl group or an alkoxy group.

Examples of the polyalkylene oxide are as follows.
polyethylene glycol, polypropylene glycol, their mono or dimethyl ether, mono or dioctyl ether, mono or dinonyl ether, and mono or didecyl ether, monoadipate, monooleate, monostearate, and monosuccinate.

A commercially available product can also be used as the alkyl alcohol polyalkylene oxide adduct. Examples of the commercially available product of the alkyl alcohol polyalkylene oxide adduct are as follows.
polyoxyethylene methyl ether (a methyl alcohol ethylene oxide adduct) (BLAUNON MP-400, MP-550, and MP-1000) manufactured by AOKI OIL INDUSTRIAL, polyoxyethylene decyl ether (a decyl alcohol ethylene oxide adduct) (FINESURF D-1303, D-1305, D-1307, and D-1310) manufactured by AOKI OIL INDUSTRIAL, polyoxyethylene lauryl ether (a lauryl alcohol ethylene oxide adduct) (BLAUNON EL-1505) manufactured by AOKI OIL INDUSTRIAL, polyoxyethylene cetyl ether (a cetyl alcohol ethylene oxide adduct) (BLAUNON CH-305 and CH-310) manufactured by AOKI OIL INDUSTRIAL, polyoxyethylene stearyl ether (a stearyl alcohol ethylene oxide adduct) (BLAUNON SR-705, SR-707, SR-715, SR-720, SR-730, and SR-750) manufactured by AOKI OIL INDUSTRIAL, randomly polymerized polyoxyethylene polyoxypropylene stearyl ether (BLAUNON SA-50/50 1000R and SA-30/70 2000R) manufactured by AOKI OIL INDUSTRIAL, polyoxyethylene methyl ether (Pluriol^{®} A760E) manufactured by BASF, and polyoxyethylene alkyl ether (EMULGEN series) manufactured by KAO.

A commercially available product can also be used as polyalkylene oxide. An example is an ethylene oxide/propylene oxide copolymer (Pluronic PE6400) manufactured by BASF.

The fluorine-based surfactant shows an excellent mold release force reducing effect and hence is effective as an internal mold release agent. The blending ratio of the component (c) in the curable composition (A) except for the fluorine-based surfactant is preferably 0 wt% or more and 50 wt% or less with respect to the sum of the components (a), (b), and (c), that is, the total mass of all the components except for the solvent (d). The blending ratio of the component (c) in the curable composition (A) except for the fluorine-based surfactant is more preferably 0.1 wt% or more and 50 wt% or less, and further preferably 0.1 wt% or more and 20 wt% or less with respect to the total mass of all the components except for the solvent (d). When the blending ratio of the component (c) except for the fluorine-based surfactant is set at 50 wt% or less, a cured film having mechanical strength to some extent can be obtained.

### <Component (d): Solvent>

The curable composition (A) contains a solvent having a boiling point of 80°C or more and less than 250°C at normal pressure as the component (d). The component (d) is a solvent that dissolves the components (a), (b), and (c). Examples are an alcohol-based solvent, a ketone-based solvent, an ether-based solvent, and a nitrogen-containing solvent. As the component (d), it is possible to use one type of a component alone, or to use two or more types of components by combining them. The boiling point at normal pressure of the component (d) is 80°C or more, preferably 140°C or more, and particularly preferably 150°C or more. The boiling point at normal pressure of the component (d) is less than 250°C, and preferably 200°C or less. If the boiling point of the component (d) at normal pressure is less than 80°C, the volatilization speed in a waiting step to be described later is too high. For this reason, the component (d) may volatilize before the droplets of the curable composition (A) combine with each other, and the droplets of the curable composition (A) may not combine with each other. Also, if the boiling point at normal pressure of the component (d) is 250°C or more, it is possible that the volatilization of the solvent (d) is insufficient in the waiting step to be described later, so the component (d) remains in the cured product of the curable composition (A).

Examples of the alcohol-based solvent are as follows.

Monoalcohol-based solvents such as methanol, ethanol, n-propanol, isopropanol, n-butanol, iso-butanol, sec-butanol, tert-butanol, n-pentanol, isopentanol, 2-methylbutanol, sec-pentanol, tert-pentanol, 3-methoxybutanol, n-hexanol, 2-methylpentanol, sec-hexanol, 2-ethylbutanol, sec-heptanol, 3-heptanol, n-octanol, 2-ethylhexanol, sec-octanol, n-nonyl alcohol, 2,6-dimethylheptanol-4, n-decanol, sec-undecyl alcohol, trimethylnonyl alcohol, sec-tetradecyl alcohol, sec-heptadecyl alcohol, phenol, cyclohexanol, methylcyclohexanol, 3,3,5-trimethylcyclohexanol, benzyl alcohol, phenylmethylcarbinol, diacetone alcohol, and cresol; and polyalcohol-based solvents such as ethylene glycol, 1,2-prpylene glycol, 1,3-butylene glycol, 2,4-pentanediol, 2-methyl-2,4-pentanediol, 1,2-hexanediol, 2,5-hexanediol, 2,4-heptanediol, 2-ethyl-1,3-hexanediol, diethylene glycol, dipropylene glycol, triethylene glycol, tripropylene glycol, and glycerin.

Examples of the ketone-based solvent are as follows.

Acetone, methylethylketone, methyl-n-propylketone, methyl-n-butyketone, diethylketone, methyl-iso-butylketone, methyl-n-pentylketone, ethyl-n-butylketone, methyl-n-hexylketone, di-iso-butylketone, trimethylnonanon, cyclohexanone, methylcyclohexanone, 2,4-pentanedione, acetonylacetone, diacetone alcohol, acetophenone, and fenthion.

Examples of the ether-based solvent are as follows.

Ethyl ether, iso-propyl ether, n-butyl ether, n-hexyl ether, 2-ethylhexyl ether, ethylene oxide, 1,2-propylene oxide, dioxolane, 4-methyldioxolane, dioxane, dimethyldioxane, 2-methoxyethanol, 2-ethoxyethanol, ethylene glycol diethyl ether, 2-n-butoxyethanol, 2-n-hexoxyethanol, 2-phenoxyethanol, 2-(2-ethylbutoxy)ethanol, ethylene glycol dibutyl ether, diethylene glycol monomethyl ether, diethylene glycol monoethyl ether, diethylene glycol diethyl ether, diethylene glycol mono-n-butyl ether, diethylene glycol di-n-butyl ether, diethylene glycol mono-n-hexyl ether, ethoxy triglycol, tetraethylene glycol di-n-butyl ether, 1-n-butoxy-2-propanol, 1-phenoxy-2-propanol, propylene glycol monomethyl ether, propylene glycol monoethyl ether, propylene glycol monopropyl ether, dipropylene glycol monomethyl ether, dipropylene glycol monoethyl ether, dipropylene glycol monopropyl ether, tripropylene glycol monomethyl ether, tetrahydrofuran, and 2-methyltetrahydrofuran.

Examples of the ester-based solvent are as follows.

Diethyl carbonate, methyl acetate, ethyl acetate, amyl acetate, γ-butyrolactone, γ-valerolactone, n-propyl acetate, iso-propyl acetate, n-butyl acetate, iso-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, methyl acetoacetate, ethyl acetoacetate, ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, glycol diacetate, methoxy triglycol acetate, ethyl propionate, n-butyl propionate, iso-amyl propionate, diethyl oxalate, di-n-butyl oxalate, methyl lactate, ethyl lactate, n-butyl lactate, n-amyl lactate, diethyl malonate, dimethyl phthalate, and diethyl phthalate.

Examples of the nitrogen-containing solvent are as follows.

N-methylformamide, N,N-dimethylformamide, N,N-diethylformamide, acetamide, N-methylacetoamide, N,N-dimethylacetamide, N-methylpropionamide, and N-methylpyrrolidone.

Of the above-described solvents, the ether-based solvent and the ester-based solvent are favorable. Note that an ether-based solvent and an ester-based solvent each having a glycol structure are more favorable from the viewpoint of good film formation properties.

Further favorable examples of the solvent are as follows.

Propylene glycol monomethyl ether, propylene glycol monoethyl ether, propylene glycol monopropyl ether, propylene glycol monomethyl ether acetate, propylene glycol monoethyl ether acetate, and propylene glycol monopropyl ether acetate.

A particularly favorable example is propylene glycol monomethyl ether acetate. Note that (ethyl)isocyanurate di(meth)acrylate is also favorable.

A favorable solvent is a solvent having at least one of an ester structure, a ketone structure, a hydroxyl group, and an ether structure. More specifically, a favorable solvent is one solvent or a solvent mixture selected from propylene glycol monomethyl ether acetate (boiling point = 146°C), propylene glycol monomethyl ether, cyclohexanone, 2-haptanone, γ-butyrolactone, and ethyl lactate.

A polymerizable compound having a boiling point of 80°C or more and less than 250°C at normal pressure is also usable as the component (d). Examples of the polymerizable compound having a boiling point of 80°C or more and less than 250°C at normal pressure are as follows.

Cyclohexyl acrylate (boiling point = 198°C), benzyl acrylate (boiling point = 229°C), isobornyl acrylate (boiling point = 245°C), tetrahydrofurfuryl acrylate (boiling point = 202°C), trimethylcyclohexyl acrylate (boiling point = 232°C), isooctyl acrylate (217°C), n-octyl acrylate (boiling point = 228°C), ethoxyethoxyethyl acrylate (boiling point = 230°C), divinylbenzene (boiling point = 193°C), 1,3-diisopropenylbenzene (boiling point = 218°C), styrene (boiling point = 145°C), and α-methylstyrene (boiling point = 165°C).

When the whole of the curable composition (A) is 100 vol%, the content of the solvent (d) can be 5 vol% or more and 95 vol% or less, and is preferably 15 vol% or more and 85 vol% or less and further preferably 50 vol% or more and 80 vol% or less. Also, the content of the solvent (d) can be 70 vol% or more and 95 vol% or less, and is preferably 70 vol% or more and 85 vol% or less and further preferably 70 vol% or more and 80 vol% or less. If the content of the solvent (d) is smaller than 5 vol%, it is difficult to obtain a thin film after the solvent (d) volatilized under the condition that a practically continuous liquid film can be obtained. On the other hand, if the content of the solvent (d) is larger than 95 vol%, it is difficult to obtain a thick film after the solvent (d) volatilized even when droplets are closely dropped by an inkjet method.

### <Temperature When Blending Curable Composition>

When preparing the curable composition (A), at least the components (a), (b), and (d) are mixed and dissolved under a predetermined temperature condition. More specifically, the predetermined temperature condition can be 0°C or more and 100°C or less. Note that the same applies to a case in which the curable composition (A) contains the component (c).

### <Viscosity of Curable Composition>

The curable composition (A) is a liquid in an arranging step to be described later. This is so because droplets of the curable composition (A) are discretely dropped on a substrate by an inkjet method in the arranging step. At 23°C, the viscosity of the curable composition (A) can be 2 mPa·s or more and 60 mPa·s or less, is preferably 3 mPa·s or more and 30 mPa·s or less and further preferably 3 mPa·s or more and 15 mPa·s or less. If the viscosity of the curable composition (A) is smaller than 2 mPa·s, the discharge property of droplets by an inkjet method may be unstable. Also, if the viscosity of the curable composition (A) is larger than 60 mPa·s, it is difficult to form droplets in a preferable volume range (for example, 1.0 to 3.0 pL).

The curable composition (A) after the solvent (d) has completely volatilized, that is, the curable composition (A) in a state in which the solvent (d) is removed can have a viscosity of, for example, 30 mPa·s or more and 10,000 mPa·s or less at 23°C. The viscosity of the composition (A) in a state in which the solvent (d) is removed can be 90 mPa·s or more and 2,000 mPa·s or less at 23°C, and is preferably 120 mPa·s or more and 1,000 mPa·s or less and further preferably 200 mPa·s or more and 500 mPa·s or less. The composition (A) in a state in which the solvent (d) is removed can also be expressed as a curable composition (A'). When the viscosity of the curable composition (A') at 23°C is set to 1,000 mPa·s or less, spreading and filling are rapidly completed when bringing the curable composition (A') into contact with a mold. Accordingly, the use of the curable composition (A) makes it possible to perform an imprinting process at high throughput, and suppress pattern defects caused by insufficient filling. Also, when the viscosity of the curable composition (A') at 23°C is set to 30 mPa·s or more, it is possible to prevent an unnecessary flow of droplets of the curable composition (A'). Furthermore, when bringing the curable composition (A') into contact with a mold, flow-out of the curable composition (A') from the end portions of the mold can be suppressed.

### <Surface Tension of Curable Composition>

The surface tension of the curable composition (A) in a state in which the solvent (component (d)) is removed can be 5 mN/m or more and 70 mN/m or less at 23°C and is preferably 7 mN/m or more and 50 mN/m or less and further preferably 10 mN/m or more and 40 mN/m or less. In other words, the surface tension of the curable composition (A') can be 5 mN/m or more and 70 mN/m or less at 23°C, and is more preferably 7 mN/m or more and 50 mN/m or less and further preferably 10 mN/m or more and 40 mN/m or less. Note that when the surface tension is high, for example, 5 mN/m or more, the capillarity strongly acts, so filling (spreading and filling) is complete within a short time period when the curable composition (A) and a mold are brought into contact with each other. Also, when the surface tension is 70 mN/m or less, a cured film obtained by curing the curable composition has surface smoothness.

### <Contact Angle of Curable Composition>

The contact angle of the curable composition (A) in a state in which the solvent (component (d)) is removed is preferably 0° or more and 90° or less and particularly preferably 0° or more and 10° or less with respect to both the surface of a substrate and the surface of a mold. In other words, the contact angle of the curable composition (A') is preferably 0° or more and 90° or less, and particularly preferably 0° or more and 10° or less with respect to both the surface of a substrate and the surface of a mold. If the contact angle is larger than 90°, the capillarity acts in a negative direction (a direction in which the contact interface between the mold and the curable composition is shrunk) inside a pattern of the mold or in a gap between the substrate and the mold, and the mold may not be filled with the curable composition. When the contact angle is small, the capillarity strongly acts, and the filling rate increases.

### <Impurities Mixed in Curable Composition>

The curable composition (A) preferably contains impurities as little as possible. Note that impurities mean components other than the components (as), (a), (b), (c), and (d) described above. Therefore, the curable composition (A) is favorably a composition obtained through a refining step. A refining step like this is preferably filtration using a filter.

As this filtration using a filter, it is favorable to mix the components (as), (a), (b), and (c) described above to obtain a mixture, and filtrate the mixture by using, for example, a filter having a pore diameter of 0.001 µm or more and 5.0 µm or less. When performing filtration using a filter, is it further favorable to perform the filtration in multiple stages, or to repetitively perform the filtration a plurality of times (cycle filtration). It is also possible to re-filtrate a liquid once filtrated through a filter, or perform filtration by using filters having different pore diameters. Examples of the filter for use in filtration are filters made of, for example, a polyethylene resin, a polypropylene resin, a fluorine resin, and a nylon resin, but the filter is not particularly limited. Impurities such as particles mixed in the curable composition can be removed through the refining step as described above. Consequently, it is possible to prevent impurities mixed in the curable composition from causing pattern defects by forming unexpected unevenness on a cured film obtained after the curable composition is cured.

When using the curable composition (A) in order to fabricate a semiconductor integrated circuit, it is favorable to avoid mixing of impurities (metal impurities) containing metal atoms in the curable composition as much as possible so as not to obstruct the operation of a product. The concentration of the metal impurities contained in the curable composition is preferably 10 ppm or less, and more preferably 100 ppb or less.

### [Substrate]

In this specification, a member on which droplets of the curable composition (A) are discretely dropped is explained as a substrate.

This substrate is a substrate to be processed, and a silicon wafer can be used in an example. The substrate can have a layer to be processed on the surface. On the substrate, another layer can also be formed below the layer to be processed. When a quartz substrate is used as the substrate, a replica (replica mold) of a mold for imprinting can be manufactured. However, the substrate is not limited to a silicon wafer or a quartz substrate. The substrate can freely be selected from those known as semiconductor device substrates such as aluminum, a titanium-tungsten alloy, an aluminum-silicon alloy, an aluminum-copper-silicon alloy, silicon oxide, and silicon nitride. Note that the surface of the substrate or of the layer to be processed is preferably treated by a surface treatment such as a silane coupling treatment, a silazane treatment, or deposition of an organic thin film, thereby improving the adhesion to the curable composition (A). As a practical example of the organic thin film to be deposited as the surface treatment, an adhesive layer described in PTL 4 can be used.

### [Pattern Forming Method and Film Forming Method]

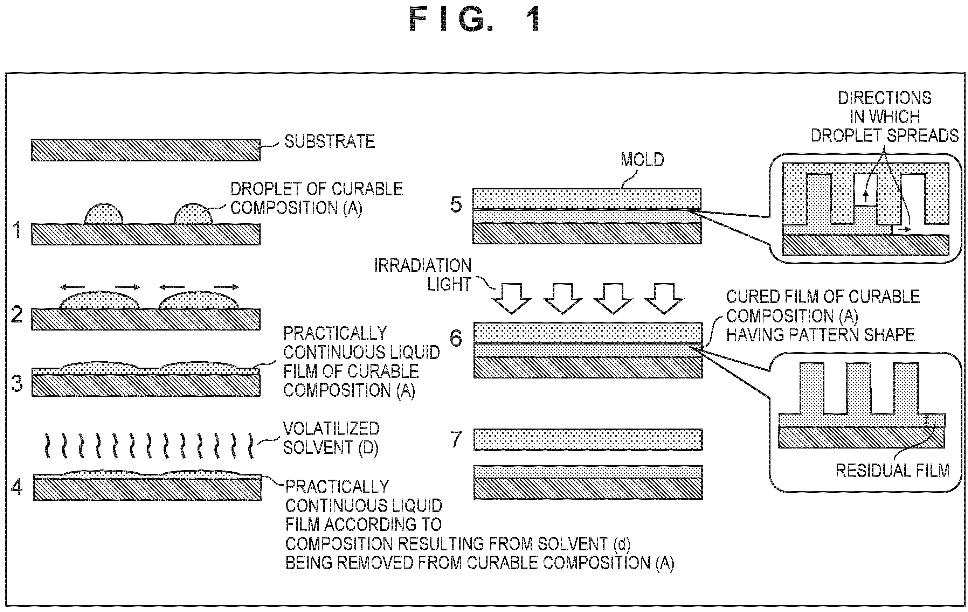

The pattern forming method according to the embodiment will be explained with reference to Fig. 1. The cured film formed by the pattern forming method is preferably a film having a pattern with a size of 1 nm or more and 10 mm or less, and more preferably a film having a pattern with a size of 10 nm or more and 100 µm or less. Generally, a film forming method of forming a film having a pattern (uneven structure) of a nano size (1 nm or more and 100 nm or less) by using light is called a photoimprint method. The film forming method according to another embodiment forms a film of a curable composition in a space between a mold and a substrate. However, the curable composition can also be cured by another energy (for example, heat or an electromagnetic wave). The film forming method can be performed as a method of forming a film having a pattern, that is, as a pattern forming method, and can also be performed as a method of forming a film (for example, a planarization film) having no pattern, that is, as a planarization film forming method.

The pattern forming method or the film forming method can include, for example, a preparation step, an arranging step, a waiting step, a contact step, a curing step, and a mold release step. The preparation step is a step of preparing an underlayer. The arranging step is a step of discretely arranging a plurality of droplets of the curable composition (A) on the underlayer. The waiting step is a step of waiting until the plurality of droplets of the curable composition (A) combine with each other and the solvent (d) volatilizes. The contact step is a step of bringing the curable composition (A or A'), preferably the curable composition (A') and a mold in contact with each other. The curing step is a step of curing the curable composition (A or A'), preferably the curable composition (A'). The mold release step is a step of releasing the mold from the cured film of the curable composition (A or A'). The arranging step is performed after the preparation step, the waiting step is performed after the arranging step, the contact step is performed after the waiting step, the curing step is performed after the contact step, and the mold release step is performed after the curing step.

### <Arranging Step>

In the arranging step, as schematically shown in [1] of Fig. 1, a plurality of droplets of the curable composition (A) are discretely arranged on a substrate. A substrate on which an underlayer is prepared or formed can be used as the substrate. In addition, the adhesion of the surface of the substrate with respect to the curable composition (A) can be improved by a surface treatment such as a silane coupling treatment, a silazane treatment, or deposition of an organic thin film.

An inkjet method is particularly favorable as the arranging method of arranging the plurality of droplets of the curable composition (A) on the substrate. It is favorable to arrange the plurality of droplets of the curable composition (A) densely on that region of the surface of the substrate, which faces a region in which recesses forming the pattern of a mold densely exist, and sparsely on that region of the surface of the substrate, which faces a region in which projections forming the pattern of the mold sparsely exist. Consequently, a residual film (to be described later) of the cured film of the curable composition (A) formed on the substrate can be controlled to have a uniform thickness regardless of the sparsity and density of the pattern of the mold.

An index called an average liquid film thickness is defined in order to prescribe the volume of the curable composition (A) to be arranged on the substrate. The average liquid film thickness is a value obtained by dividing the total volume of the curable composition (A) (except the solvent (d)) to be arranged in the arranging step by the area of a film formation region of the mold. The volume of the cured product or the cured film of the curable composition (A) (except the solvent (d)) is the sum total of the volumes of the individual droplets of the curable composition (A) after the solvent (d) volatilized. According to this definition, the average liquid film thickness can be prescribed regardless of the state of unevenness even when the substrate surface is uneven.

### <Waiting Step>

The waiting step is provided between the arranging step and the contact step. Here, a value obtained by dividing the total volume of the plurality of droplets of the curable composition (A) dropped in one-time pattern formation by the total area of regions (pattern formation regions) in which patterns are formed in one-time pattern formation is defined as an average film thickness. In the waiting step, as schematically shown in [2] of Fig. 1, the droplets of the curable composition (A) spread on the substrate. Consequently, the whole pattern formation region of the substrate 1 is covered with the curable composition (A). As schematically shown in [3] of Fig. 1, when the average film thickness is 130 nm or more, the droplets of the curable composition (A) combine with each other on the substrate and form a practically continuous liquid film. This will be described later. The surface of the liquid film is planarized when the average film thickness is 150 nm or more. This will be described later, too. A liquid film having an average film thickness of 130 nm or more can be obtained by arranging the droplets of the curable composition (A) having a volume of 1.0 pL or more at a density of 130 droplets/mm² or more. Likewise, a liquid film having an average film thickness of 150 nm can be obtained by arranging the droplets of the curable composition (A) having a volume of 1.0 pL or more at a density of 150 droplets/mm² or more.

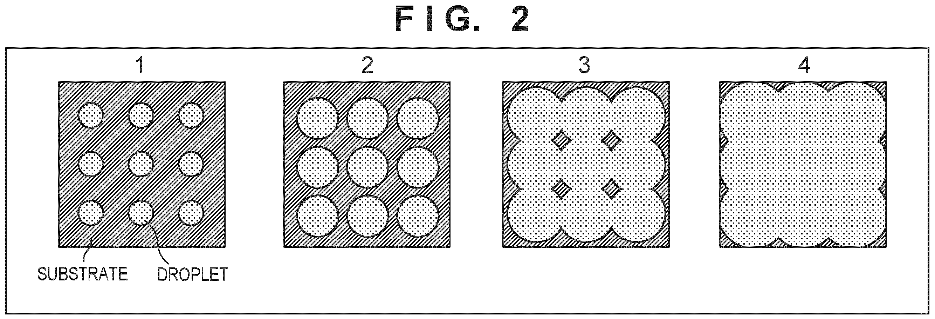

A flow behavior during the waiting step of the droplets of the curable composition (A) arranged on the substrate will be explained with reference to Fig. 2. The plurality of droplets of the curable composition (A) are discretely arranged on the substrate as shown in [1] of Fig. 2, and each droplet gradually spreads on the substrate as shown in [2] of Fig. 2. Then, the adjacent droplets of the curable composition (A) begin combining with each other on the substrate to form a liquid film as shown in [3] of Fig. 2, and a continuous liquid film is formed (the surface of the substrate is covered with the curable composition (A) and there is no more exposed surface) as shown in [4] of Fig. 2. The state of the curable composition (A) as shown in [4] of Fig. 2 can be understood as "a practically continuous liquid film".

In addition, as schematically shown in Fig. [4] of Fig. 1, the solvent (d) contained in the liquid film is volatilized in the waiting step. Assuming that the total weight of the components except for the solvent (d) is 100 vol%, the residual amount of the solvent (d) in the liquid film after the waiting step is preferably 10 vol% or less. If the residual amount of the solvent (d) is larger than 10 vol%, the mechanical properties of the cured film may deteriorate.

In the waiting step, it is possible to perform a baking step of heating the substrate and the curable composition (A), or ventilate the atmospheric gas around the substrate, for the purpose of accelerating the volatilization of the solvent (d). Heating can be performed at, for example, 30°C or more and 200°C or less, preferably 80°C or more and 150°C or less, and particularly preferably 90°C or more and 110°C or less. The heating time can be 10 sec or more and 600 sec or less. The baking step can be performed by using a known heater such as a hotplate or an oven.

The execution time of the waiting step can fall within the range of, for example, 0.1 to 600 sec, and preferably falls within the range of 10 to 300 sec. If the execution time of the waiting step is shorter than 0.1 sec, the combination of the droplets of the curable composition (A) becomes insufficient, so no practically continuous liquid film may be formed. If the waiting step exceeds 600 sec, the productivity decreases. To suppress the decrease in productivity, therefore, it is also possible to sequentially move substrates completely processed in the arranging step to the waiting step, perform the waiting step in parallel to a plurality of substrates, and sequentially move the substrates completely processed in the waiting step to the contact step. Note that in the related art, a few thousands of seconds to a few tens of thousands of seconds are theoretically required before a practically continuous liquid film is formed. In practice, however, no continuous liquid film can be formed because the spread of the droplets of the curable composition stagnates due to the influence of volatilization.

When the solvent (d) volatilizes in the waiting step, the practically continuous liquid film of a composition containing the components (as), (a), (b), and (c), that is the curable composition (A') remains. The average film thickness of the practically continuous liquid film of the curable composition (A) from which the solvent (d) was removed, that is, the curable composition (A') becomes smaller than the liquid film by the volatilized amount of the solvent (d). A state in which the entire pattern formation region of the substrate is covered with the practically continuous liquid film of the curable composition (A') is maintained.

### <Contact Step>

In the contact step, as schematically shown in [5] of Fig. 1, the mold is brought into contact with the practically continuous liquid film of the curable composition (A) from which the solvent (d) is removed, that is, the curable composition (A'). The contact step can include a step of a changing a state in which the curable composition (A') and the mold are not in contact with each other to a state in which they are in contact with each other, and a step of maintaining the state in which they are in contact with each other. As a consequence, the liquid of the curable composition (A') is filled in recesses of fine patterns on the surface of the mold, and the filled liquid forms a liquid film filled in the fine patterns of the mold.

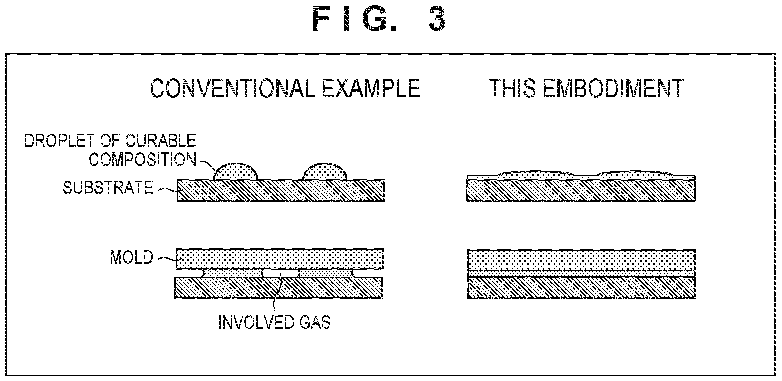

In the waiting step, if the solvent (d) is removed from the curable composition (A), and the practically continuous liquid film of the curable composition (A') is formed, the volume of a gas involved between the mold and the substrate becomes small. Accordingly, spreading of the curable composition (A') in the contact step can rapidly be completed. Fig. 3 shows the comparison (difference) between the contact step in the related art disclosed in PTL 1 and the like and the contact step according to this embodiment.

When spreading and filling of the curable composition (A') are quickly completed in the contact step, it is possible to shorten the time (the time required for the contact step) for maintaining the state in which the mold is in contact with the curable composition (A'). Since shortening the time required for the contact step leads to shortening the time required for pattern formation (film formation), the productivity improves. The execution time of the contact step is preferably 0.1 sec or more and 3 sec or less, and particularly preferably 0.1 sec or more and 1 sec or less. If the contact step is shorter than 0.1 sec, spreading and filling become insufficient, so many defects called incomplete filling defects tend to occur.

When the curing step includes a photoirradiation step, a mold made of a light-transmitting material is preferably used as the mold. Favorable practical examples of the material forming the mold are glass, quartz, PMMA, a photo-transparent resin such as a polycarbonate resin, a transparent metal deposition film, a soft film such as polydimethylsiloxane, a photo-cured film, and a metal film. Note that when using the photo-transparent resin as the material forming the mold, a resin that does not dissolve in components contained in a curable composition is preferably selected. Quartz is suitable as the material forming the mold because the thermal expansion coefficient is small and pattern distortion is small.

A pattern formed on the surface of the mold can have a height of, for example, 4 nm or more and 200 nm or less. As the pattern height of the mold decreases, it becomes possible to decrease the force of releasing the mold from the cured film of the curable composition, that is, the mold release force in the mold release step, and this makes it possible to decrease the number of mold release defects remaining in the mold because the pattern of the curable composition is torn off. Also, in some cases, the pattern of the curable composition elastically deforms due to the impact when the mold is released, and adjacent pattern elements come in contact with each other and adhere to each other or break each other. To avoid these inconveniences, it is advantageous to make the height of pattern elements be about twice or less the width of the pattern elements (make the aspect ratio be 2 or less). On the other hand, if the height of pattern elements is too small, the processing accuracy of the substrate decreases.

A surface treatment can also be performed on the mold before performing the contact step, in order to improve the detachability of the mold with respect to the curable composition (A). An example of this surface treatment is to form a mold release agent layer by coating the surface of the mold with a mold release agent. Examples of the mold release agent to be applied on the surface of the mold are a silicon-based mold release agent, a fluorine-based mold release agent, a hydrocarbon-based mold release agent, a polyethylene-based mold release agent, a polypropylene-based mold release agent, a paraffine-based mold release agent, a montane-based mold release agent, and a carnauba-based mold release agent. It is also possible to suitably use a commercially available coating-type mold release agent such as Optool^{®} DSX manufactured by Daikin. Note that it is possible to use one type of a mold release agent alone, or use two or more types of mold release agents together. Of the mold release agents described above, fluorine-based and hydrocarbon-based mold release agents are particularly favorable.

In the contact step, the pressure to be applied to the curable composition (A) when bringing the mold into contact with the curable composition (A) is not particularly limited, and is, for example, 0 MPa or more and 100 MPa or less. Note that when bringing the mold into contact with the curable composition (A), the pressure to be applied to the curable composition (A) is preferably 0 MPa or more and 50 MPa or less, more preferably 0 MPa or more and 30 MPa or less, and further preferably 0 MPa or more and 20 MPa or less.

The contact step can be performed in any of a normal air atmosphere, a reduced-pressure atmosphere, and an inert-gas atmosphere. However, the reduced-pressure atmosphere or the inert-gas atmosphere is favorable because it is possible to prevent the influence of oxygen or water on the curing reaction. Practical examples of an inert gas to be used when performing the contact step in the inert-gas atmosphere are nitrogen, carbon dioxide, helium, argon, various freon gases, and gas mixtures thereof. When performing the contact step in a specific gas atmosphere including a normal air atmosphere, a favorable pressure is 0.0001 atm or more and 10 atm or less.

### <Curing Step>

In the curing step, as schematically shown in [6] of Fig. 1, the curable composition (A') is cured by being irradiated with irradiation light as curing energy, thereby forming a cured film. In the curing step, for example, the curable composition (A) is irradiated with the irradiation light through the mold. More specifically, the curable composition (A) filled in the fine pattern of the mold is irradiated with the irradiation light through the mold. Consequently, the curable composition (A) filled in the fine pattern of the mold is cured and forms a cured film having the pattern.

The irradiation light is selected in accordance with the sensitivity wavelength of the curable composition (A). More specifically, the irradiation light is properly selected from ultraviolet light, X-ray, and an electron beam each having a wavelength of 150 nm or more and 400 nm or less. Note that the irradiation light is particularly preferably ultraviolet light. This is so because many compounds commercially available as curing assistants have sensitivity to ultraviolet light. Examples of a light source that emits ultraviolet light are a high-pressure mercury lamp, an ultrahigh-pressure mercury lamp, a low-pressure mercury lamp, a Deep-UV lamp, a carbon arc lamp, a metal halide lamp, a xenon lamp, a KrF excimer laser, an ArF excimer laser, and an F₂ laser. Note that the ultrahigh-pressure mercury lamp is particularly favorable as the light source for emitting ultraviolet light. It is possible to use one light source or a plurality of light sources. Light can be emitted to the entire region of the curable composition (A) filled in the fine pattern of the mold, or to only a partial region thereof (by limiting the region). It is also possible to intermittently emit light to the entire region of the substrate a plurality of times, or to continuously emit light to the entire region of the substrate. Furthermore, a first region of the substrate can be irradiated with light in a second irradiation process, and a second region different from the first region of the substrate can be irradiated with light in the second irradiation process.

### <Mold Release Step>

In the mold release step, as schematically shown in [7] of Fig. 1, the mold is released from the cured film. When the mold is released from the cured film having the pattern, the cured film having a pattern formed by inverting the fine pattern of the mold is obtained in an independent state. In this state, a cured film remains in recesses of the cured film having the pattern. This film is called a residual film.

A method of releasing the mold from the cured film having the pattern can be any method provided that the method does not physically break a part of the cured film having the pattern during the release, and various conditions and the like are not particularly limited. For example, it is possible to fix the substrate and move the mold away from the substrate. It is also possible to fix the mold and move the substrate away from the mold. Furthermore, the mold can be released from the cured film having the pattern by moving both and the substrate in exactly opposite directions.

### <Repetition>

A series of steps (a fabrication process) from the above-described arranging step to the mold release step make it possible to obtain a cured film having a desired concave-convex pattern shape (a pattern shape conforming to the uneven shape of the mold) in a desired position.

In the above-described pattern forming method, a repetition unit (shot) from the arranging step to the mold release step can repetitively be performed a plurality of times on the same substrate, so the cured film having a plurality of desired patterns in desired positions of the substrate can be obtained.

### [Planarization Film Forming Method]

An example in which the film forming method is applied to a planarization film forming method will be explained below. The planarization film forming method can include, for example, an arranging step, a waiting step, a contact step, a curing step, and a mold release step. The arranging step is a step of arranging droplets of the curable composition (A) on a substrate. The waiting step can be a step of waiting until the droplets of the curable composition (A) combine with each other and the solvent (d) volatilizes. The contact step is a step of bringing the curable composition (A or A'), preferably the curable composition (A') and a mold into contact with each other. The curing step is a step of curing the curable composition (A or A'), preferably the curable composition (A'). The mold release step is a step of releasing the mold from the cured film of the curable composition (A or A'). In the planarization film forming method, a substrate having unevenness having a difference in height of about 10 to 1,000 nm is used as the substrate, a mold having a flat surface is used as the mold, and a cured film having a surface conforming to the flat surface of the mold is formed through the contact step, the curing step, and the mold release step. In the arranging step, the droplets of the curable composition (A) are densely arranged in recesses of the substrate, and sparsely arranged on projections of the substrate. The waiting step is performed after the arranging step, the contact step is performed after the waiting step, the curing step is performed after the contact step, and the mold release step is performed after the curing step.

### [Article Manufacturing Method]

A cured film having a pattern or a film formed by the pattern forming method or the film forming method can directly be used as at least a partial constituent member of various kinds of articles. Alternatively, a cured film having a pattern formed by the pattern forming method can temporarily be used as a mask for etching or ion implantation with respect to a substrate (a layer to be processed when the substrate has the layer to be processed). This mask is removed after etching or ion implantation is performed in a substrate processing step. Consequently, various kinds of articles can be manufactured.

When removing a cured product in recesses of a pattern of the cured product by etching, a practical method is not particularly limited, and a conventionally known method such as dry etching can be used. A conventionally known dry etching apparatus can be used in this dry etching. A source gas for dry etching is appropriately selected in accordance with an element composition of the cured product to be etched, and it is possible to use halogen gases such as CF₄, C₂F₆, C₃F₈, CCl₂F₂, CCl₄, CBrF₃, BCl₃, PCl₃, SF₆, and Cl₂. As the source gas, it is also possible to use gases containing oxygen atoms such as O₂, CO, and CO₂, inert gases such as He, N₂, and Ar, and gases such as H₂ and NH₃. Note that these gases can also be used as a gas mixture. In this case, the photo-cured film is required to have a high dry etching resistance in order to process the base substrate with high yield.

In the process of processing the base substrate according to this embodiment, the cured film of the curable composition can be used as an etching mask. The curable composition from which the solvent is removed preferably contains silicon atoms of 20 wt% or more. In this case, the cured film of the curable composition can exhibit an excellent dry etching resistance to the gas that processes the base substrate. The curable composition from which the solvent is removed more preferably contains silicon atoms of 22 wt% or more, and further preferably contains silicon atoms of 23 wt% or more. In an example, the content of the silicon atoms in the curable composition from which the solvent is removed can be 36 wt% or less, but the present invention is not limited to this. If the uppermost surface of the base substrate is made of chromium (Cr), for example, a halogen gas such as Cl₂ can be used as the etching gas.

The content of Si atoms in the curable composition from which the solvent is removed can be calculated by, for example, the formula below.

### (Method of Calculating Si Atom Content)

(weight of component (as)) × (Si atom content in component (as))/(weight of component (as) + weight of component (a) + weight of component (b) + weight of component (c))

If the glass transition temperature of the curable composition is much higher than the temperature at the time of mold release, the cured product at the time of mold release exhibits a firm glass state, that is, a high mechanical strength. For this reason, collapse or break of the pattern caused by impact of mold release hardly occurs. Hence, when executing the mold release step at room temperature, the glass transition temperature of the cured product is preferably 70°C or more, more preferably 100°C or more, and particularly preferably 150°C or more.

The glass transition temperature of the cured product can be measured using differential scanning calorimetry (DSC) or a dynamic viscoelasticity measuring apparatus. For example, in a case where DSC is used, a line obtained by extending the baseline (a DSC curve portion in a temperature region where neither transition nor reaction occur in a test piece) of a DSC curve on the low temperature side to the high temperature side, and a tangent drawn at a point where the gradient of the curve of a stepwise change portion of glass transition is maximum are acquired. An extrapolated glass transition start temperature (Tig) is obtained from the intersection of the line and the tangent, and this can be obtained as the glass transition temperature. STA-6000 (manufactured by Perkin Eimer) or the like can be used as the main apparatus. On the other hand, in a case where a dynamic viscoelasticity measuring apparatus is used, a temperature at which the loss sine (tanδ) of the photo-cured product is maximum is defined as the glass transition temperature. MCR301 (manufactured by Anton Paar) or the like can be used as the main apparatus capable of measuring the dynamic viscoelasticity.

An article is, for example, an electric circuit element, an optical element, MEMS, a recording element, a sensor, or a mold. Examples of the electric circuit element are volatile or nonvolatile semiconductor memories such as a DRAM, an SRAM, a flash memory, and an MRAM, and semiconductor elements such as an LSI, a CCD, an image sensor, and an FPGA. Examples of the optical element are a micro lens, a light guide body, a waveguide, an antireflection film, a diffraction grating, a polarizer, a color filter, a light-emitting element, a display, and a solar battery. Examples of the MEMS are a DMD, a microchannel, and an electromechanical transducer. Examples of the recording element are optical disks such as a CD and a DVD, a magnetic disk, a magneto-optical disk, and a magnetic head. Examples of the sensor are a magnetic sensor, a photosensor, and a gyro sensor. An example of the mold is a mold for imprinting.

In addition, a well-known photolithography step such as an imprint lithography technique or an extreme ultraviolet exposure technique (EUV) can be performed on the planarization film formed by the planarization film forming method. It is also possible to stack a spin-on-glass (SOG) film and/or a silicon oxide layer, and perform a photolithography step by applying a curable composition on that. Consequently, a device such as a semiconductor device can be fabricated. It is further possible to form an apparatus including the device, for example, an electronic apparatus such as a display, a camera, or a medical apparatus. Examples of the device are an LSI, a system LSI, a DRAM, an SDRAM, an RDRAM, a D-RDRAM, and a NAND flash memory.

### [Inverting Process]

The curable composition (A) is useful for an inverting process (inverted pattern forming method) of forming an inverted pattern. The inverting process can include the following steps.
· Inverted pattern forming step of arranging the curable composition (A) to fill the recesses of a first film having a pattern including recesses and projections and curing the curable composition, thereby forming a second film including an inverted layer filled in the recesses.
· Excess inverted layer removing step of removing a part (excess inverted layer) of the second film to expose the projections.
· Etching step of patterning (etching) the first film using the inverted layer remaining in the recesses as a mask, thereby forming an inverted pattern formed by the patterned first film.

The inverting process is advantageous in processing a layer to be processed. When processing the layer to be processed, the first film having a pattern including recesses and projections is formed on the layer to be processed, an inverted pattern is formed after that, and the layer to be processed is etched using the inverted pattern as a mask, thereby processing the layer to be processed. Hence, the inverting process of processing the layer to be processed can include the following steps.
· Pattern forming step of forming the first film having the pattern including recesses and projections on the layer to be processed.
· Inverted layer forming step of arranging the curable composition (A) to fill the recesses of the first film having the pattern including recesses and projections and curing the curable composition, thereby forming the second film including the inverted layer filled in the recesses.
· Excess inverted layer removing step of removing a part (excess inverted layer) of the second film to expose the projections.
· Etching step of patterning (etching) the first film using the inverted layer remaining in the recesses as a mask, thereby forming the inverted pattern formed by the patterned first film.
· Processing step of processing the layer to be processed using the inverted layer as a mask.

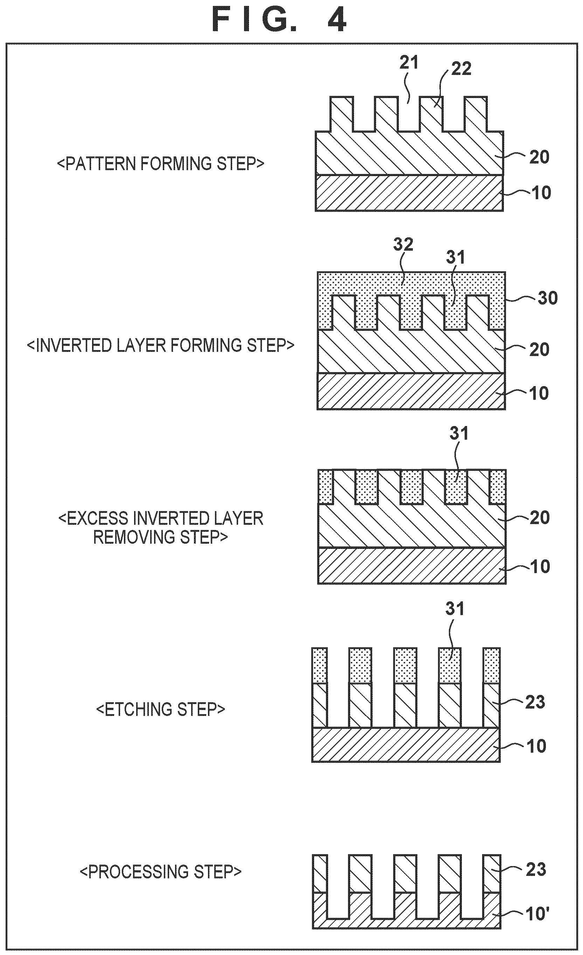

An example of the inverting process of processing the layer to be processed will be described below in detail with reference to Fig. 4.

### <Pattern Forming Step>

In the pattern forming step, processing from the arranging step to the mold release step in the above-described pattern forming method is executed on a layer 10 to be processed using a curable composition (B) that does not contain inorganic elements such as silicon atoms, thereby forming a cured film 20 that is the first film having a pattern including recesses 21 and projections 22. As the curable composition (B), for example, a curable composition described in Japanese Patent Laid-Open No. 2016-162862 can be used, but the present invention is not limited to this.

### <Inverted Layer Forming Step>

In the inverted layer forming step, the curable composition (A) is arranged on the cured film 20 that is the first film having the pattern including the recesses 21 and the projections 22 to fill the inverted layer 21, and the curable composition (A) is cured, thereby forming a second film 30 including an inverted layer 21 filled in the recesses 21. The second film 30 can include an excess inverted layer 32 in addition to the inverted layer 21. Curing of the curable composition (A) can be performed by, for example, irradiating the curable composition (A) with light serving as curing energy or heating the curable composition (A). The light serving as curing energy can appropriately be selected from, for example, ultraviolet light having a wavelength of 150 nm or more and 400 nm or less, X-rays, or an electron beam, and ultraviolet light is particularly preferable. Heating is performed at, for example, 30°C or more and 400°C or less, preferably at 80°C or more and 250°C or less, particularly preferably at 90°C or more and 220°C or less. The heating time can be 10 sec or more and 600 sec or less. The baking step can be executed using a known heating device such as a hot plate or an oven.

### <Excess Inverted Layer Removing Step>

As described above, in the inverted layer forming step, the excess inverted layer 32 can be formed as a part of the inverted layer 30 even on the projections 22 of the cured film 20 that is the first film. In the inverted layer forming step, the excess inverted layer 32 that is a part of the second film 30 is removed to expose the projections 22.

The method of removing the excess inverted layer 32 is not particularly limited and, for example, dry etching can be used. A known dry etching apparatus can be used for dry etching. A source gas for dry etching is appropriately selected in accordance with an element composition of the inverted layer, and it is possible to use fluorocarbon gases such as CF₄, CHF₄, C₂F₆, C₃F₈, C₄F₈, C₅F₈, C₄F₆, CCl₂F₂, and CBrF₃, or halogen gases such as CCl₄, BCl₃, PCl₃, SF₆, and Cl₂. Note that these gases can also be used as a gas mixture.

### <Etching Step>

In the etching step, the cured film 20 that is the first film is patterned (etched) using the inverted layer 31 remaining in the recesses 21 as a processing mask, thereby forming an inverted pattern 23 formed by the patterned cured film 20. The etching step can be continued, for example, until the surface of the substrate 10 to be processed is exposed. If an intermediate transfer layer (C) that does not contain inorganic elements such as silicon atoms is formed between the surface of the substrate 10 to be processed and the cured film 20 that is the first film, like spin on carbon (SOC), the intermediate transfer layer (C) can also be etched.

With the above-described step, the inverted pattern 23 in which the recesses and the projections of the cured film 20 as the first film are inverted can be formed. A detailed method of etching is not particularly limited and, for example, dry etching can be used. A known dry etching apparatus can be used for dry etching. A source gas for dry etching is appropriately selected in accordance with an element composition of the cured film 20, and it is possible to use gases containing oxygen atoms such as O₂, CO, and CO₂, inert gases such as He, N₂, and Ar, or gases such as N₂, H₂, and NH₃. Note that these gases can also be used as a gas mixture.

The inverted layer 31 made of the curable composition (A) that is a silicon-containing polymerizable compound exhibits a high resistance to plasma formed using the above-described gas. However, the cured film 20 and the intermediate transfer layer (C), which contain no silicon atoms, have a low resistance to the plasma. It is therefore possible to easily form the inverted pattern 23 in which the pattern of the cured film 20 before the inverted layer forming step is inverted.

### <Processing Step>

In the processing step, the layer to be processed of the substrate 10 to be processed is etched using the inverted pattern 23 as a processing mask, thereby processing the layer to be processed. Alternatively, in the processing step, ion implantation may be performed for the layer to be processed using the inverted pattern 23 as a processing mask. Etching of the layer to be processed may be executed under the same conditions as etching of the above-described excess inverted layer, or may be executed under different conditions suitable for etching of the layer to be processed. After processing of the layer to be processed, the inverted pattern 23 that is the processing mask may be removed.

### [Examples]

More practical examples will be explained in order to supplement the above-described embodiments.

### <Conditions for Obtaining Practically Continuous Liquid Film>

A plurality of droplets of a curable composition (A) having a surface tension of 33 mN/m, a viscosity of 30 mPa·s, and a volume of 1 pL were dropped (arranged) in a square array at a predetermined interval on a flat substrate. A behavior that each droplet of the curable composition (A) spread on the substrate was calculated by numerical calculation based on Navier-Stokes equations that had undergone a thin-film approximation method (lubrication theory) with a free surface. The thickness of the liquid film at the center of a drop position (the thickest portion of the liquid film on the substrate) and the thickness of the liquid film at the center of a square formed by four droplets arrayed in a square (the thinnest portion of the liquid film on the substrate) after the elapse of 300 sec from the drop of the droplets of the curable composition (A) are shown in Table 1 below. Note that assume that the contact angle of a droplet of the curable composition (A) with respect to the substrate is 0°, and volatilization of a solvent (d) during 300 sec from the drop of the droplets of the curable composition (A) can be neglected.

**[Table 1]**

| | Example 1 | Example 2 | Example 3 | Example 4 | Example 5 | Comparative Example 1 | Comparative Example 2 | Comparative Example 3 |
|---|---|---|---|---|---|---|---|---|
| droplet pitch (µm) | 63 | 70 | 81 | 84 | 88 | 91 | 95 | 100 |
| average film thickness (nm) | 252 | 204 | 153 | 142 | 130 | 120 | 111 | 100 |
| thickness of thickest portion (nm) | 252 | 204 | 153 | 145 | 160 | 164 | 170 | 180 |
| thickness of thinnest portion (nm) | 252 | 204 | 153 | 138 | 84 | 0 | 0 | 0 |

Referring to Table, 1, in Examples 1 to 5 in which the average film thickness was 130 nm or more, it was found that the whole region of the substrate was covered with the curable composition (A). Furthermore, in Examples 1 to 3 in which the average film thickness was 150 nm or more, it was found that a flat liquid film in which the thickness of the thickest portion and the thickness of the thinnest portion were substantially 0 nm was formed.

### <Examination of Controllability of Average Film Thickness>

Both the droplet volume and the square array pitch of the curable composition (A) can be changed, but the liquid film thickness before volatilization of the solvent (d) is 130 nm, as described above, even in the region with the minimum liquid film thickness. The thickness of the liquid film remaining after volatilization of the solvent (d) from a state in which a practically continuous liquid film is obtained is calculated. Assuming that the minimum value of the square array pitch of droplets of the curable composition (A) dropped onto the substrate was 35 µm, the maximum value of the thickness before the mold was brought into contact was calculated. The minimum value of the thickness of the liquid film before volatilization of the solvent (d) with which a practically continuous liquid film was obtained was calculated as 130 nm, as described above. For this reason, the minimum value of the thickness of the liquid film before the mold is brought into contact can be calculated by main component concentration (vol%) × 130 nm. Here, the main component concentration (vol%) is a value obtained by subtracting vol% of the solvent (d) from 100 vol%. A case where the volume of the droplet of the curable composition (A) is 1.0 pL is shown in Table 2 below, and a case where the volume of the droplet of the curable composition (A) is 3.0 pL is shown in Table 3 below.

**[Table 2]**

| Average residual film thickness in a case where the volume of the droplet of the curable composition (A) is 1.0 pL | | | | | | |
|---|---|---|---|---|---|---|
| | Example 6 | Example 7 | Example 8 | Example 9 | Example 10 | Example 11 |
| main component concentration (vol%) | 5 | 10 | 15 | 20 | 25 | 30 |
| maximum film thickness (nm) | 41 | 82 | 122 | 163 | 205 | 245 |
| minimum film thickness (nm) | 7 | 13 | 20 | 26 | 33 | 39 |

**[Table 3]**

| Average residual film thickness in a case where the volume of the droplet of the curable composition (A) is 3.0 pL | | | | | | |
|---|---|---|---|---|---|---|
| | Example 6 | Example 7 | Example 8 | Example 9 | Example 10 | Example 11 |
| main component concentration (vol%) | 5 | 10 | 15 | 20 | 25 | 30 |
| maximum film thickness (nm) | 123 | 245 | 366 | 490 | 615 | 735 |
| minimum film thickness (nm) | 7 | 13 | 20 | 26 | 33 | 39 |

In an example, the film thickness required in both the pattern forming method and the planarization film forming method in a photolithography step for manufacturing a semiconductor device is 30 nm or more and 200 nm or less. As shown in Tables 2 and 3, if the main component concentration is 10 vol% or more, a thick film having a thickness of 200 nm or more can be obtained. If the main component concentration is 20 vol% or less, a thin film having a thickness of 30 nm or less can be formed. It is therefore particularly preferable that the main component concentration of the curable composition (A) is 10 vol% or more and 20 vol% or less, that is, the content of the solvent (d) is 80 vol% or more and 90 vol% or less. On the other hand, if the film thickness is 200 nm or more, the content of the solvent (d) can be 5 vol% or more and 80 vol% or less. For this reason, the content of the solvent (d) according to the present invention can be adjusted within the range of 5 vol% or more and 90 vol% or less in accordance with the application purpose.

### <Evaluation of Discharge Property and Filling Property of Inkjet>

The curable composition (A) was mixed such that the total weight of components (as), (a), (b), and (c) was 100 wt% in accordance with Table 4 below. Also, the viscosities of the curable compositions (A) and the curable compositions (A) mixed without using the component (d) at 23°C were measured. The Si atom contents and Tg after curing of the curable compositions at the time of removal of the component (d) were calculated and measured by the above-described methods, and the result is shown in Table 5. Abbreviations in Table 4 are as follows.

### "Component (as)"

### SIM6487.6:

AC-SQ TA-100: silsesquioxane derivatives with acrylate groups (manufactured by TOAGOSEI)
MAC-SQ TM-100: silsesquioxane derivatives with methacrylate groups (manufactured by TOAGOSEI)
AC-SQ SI-20: silsesquioxane derivatives with acrylate groups (manufactured by TOAGOSEI)
MAC-SQ SI-20: silsesquioxane derivatives with methacrylate groups (manufactured by TOAGOSEI)
MA-Si-12: methacrylate-introduced linear dimethylsiloxane derivatives (synthetic product)
8-ring: acrylate-introduced ring siloxane derivatives (synthetic product)
10-ring: acrylate-introduced ring siloxane derivatives (synthetic product)

### "Component (a)"

Viscoat #150: tetrahydrofurfuryl acrylate (manufactured by OSAKA ORGANIC CHEMICAL INDUSTRY)
Viscoat #160: benzyl acrylate (manufactured by OSAKA ORGANIC CHEMICAL INDUSTRY)
Viscoat #200: cyclic trimethylolpropane formal acrylate (manufactured by OSAKA ORGANIC CHEMICAL INDUSTRY)
Viscoat #295: trimethylolpropane triacrylate (manufactured by OSAKA ORGANIC CHEMICAL INDUSTRY)
DCP-A: dimethylol-tricyclodecanediacrylate (manufactured by KYOEISHA CHEMICAL)

### "Component (b)"

Omnirad 819: phenylbis(2,4,6-trimethylbenzoyl)phosphine oxide (manufactured by IGM Resin)

### "Component (d)"

PGMEA: propylene glycol monomethyl ether acetate (manufactured by KANTO CHEMICAL)
DEG: diethylene glycol (manufactured by KISHIDA CHEMICAL)
NMP: N-methylpyrrolidone (manufactured by KISHIDA CHEMICAL)

### <Evaluation of Inkjet Discharge>

For inkjet discharge evaluation, a commercially available industrial material printer DMP-2850 (manufactured by Fujifilm) was used. Examples 12 to 32 and Comparative Examples 4 to 8 obtained in Table 4 were filled in 1-pL cartridges, discharge states were observed by an internal discharge observation camera, and evaluation was done based on the following determination criteria.

### (Evaluation Criteria)

AAA: At a flying speed of 11 m/sec or more, no distortion was observed at all.
AA: At a flying speed of 11 m/sec or more, very slight distortion without practical influence was observed.
A: At a flying speed of 10 m/sec or more, very slight distortion without practical influence was observed.
B: Discharge was not performed.

### <Evaluation of Filling Property>

Under a condition that the thickness of a liquid film before volatilization of the solvent (d) was 130 nm, each of the curable compositions (A) of Examples 12 to 32 and Comparative Examples 4 to 8 was discretely dropped (arranged) on a silicon substrate, time until a practically continuous liquid film was formed was measured, and the filling property was evaluated based on the following determination criteria.

### (Evaluation Criteria)

AAA: A practically continuous liquid film was formed in a time less than 100 sec.
AA: A practically continuous liquid film was formed in a time of 100 sec or more and less than 200 sec.
A: A practically continuous liquid film was formed in a time of 200 sec or more and less than 300 sec.
B: A practically continuous liquid film was not formed even after the elapse of time of 300 sec.

### <Evaluation of Pattern Collapse>

Patterns obtained by executing the arranging step, the waiting step, the contact step, the curing step, and the mold release step for the curable compositions (A) of Examples 12 to 32 and Comparative Examples 4 to 8 using a silica mold in which a line-and-space (L/S) pattern having a depth of 50 nm and a width of 20 nm was formed in the whole region were observed and evaluated based on the following determination criteria.

### (Evaluation Criteria)

AAA: Pattern collapse was observed in a region less than 0.1% the pattern formation region.
AA: Pattern collapse was observed in a region less than 1% the pattern formation region.
A: Pattern collapse was observed in a region less than 10% the pattern formation region.
B: Pattern collapse was observed in a region 10% or more the pattern formation region.

### <Evaluation of Dry Etching Resistance>

Cured films obtained above were exposed to oxygen plasma in a dry etching apparatus, and a weight change of each remaining film was measured and evaluated based on the following determination criteria.

### (Evaluation Criteria)

AAA: The weight of a remaining cured film was 49% or more the weight before etching.
AA: The weight of a remaining cured film was 47% or more the weight before etching.
A: The weight of a remaining cured film was 43% or more the weight before etching.
B: The weight of a remaining cured film was less than 43% the weight before etching.

Table 6 shows the above-described evaluation results. It is found that if the viscosity of the curable composition at 23°C is 2 mPa·s or more and 60 mPa·s or less, IJ discharge is excellent, and the viscosity is preferably 5 mPa·s or more and 30 mPa·s or less and further preferably 5 mPa·s or more and 15 mPa·s or less. It is found that if the viscosity at 23°C when the solvent is removed is 30 mPa·s or more and 10,000 mPa·s or less, the filling property is excellent, and the viscosity is preferably 90 mPa·s or more and 2,000 mPa·s or less and further preferably 120 mPa·s or more and 1,000 mPa·s or less.

If the glass transition temperature of the cured curable composition was 150°C or more, pattern collapse was observed in a region less than 0.1% the pattern formation region. If the glass transition temperature was 100°C or more and less than 150°C, pattern collapse was observed in a region less than 1% the pattern formation region. If the glass transition temperature was 70°C or more and less than 100°C, pattern collapse was observed in a region less than 10% the pattern formation region. If the glass transition temperature was less than 70°C, pattern collapse was observed in a region 10% or more the pattern formation region. In all cases, the degree was very slight.

If the Si atom content of the curable composition when the solvent was removed was 23% or more, the weight of the remaining cured film was 49% or more the weight before etching. If the Si atom content was 22% or more, a film 47% or more remained as the cured film. If the Si atom content was 20% or more, a film 43% or more remained as the cured film.

**[Table 4]**

| | Polymerizable Si monomer as1 (monofunctional) | | Polymerizable Si monomer as2 (polyfunctional) | | Polymerizable Si monomer as1 (monofunctional) | | Polymerizable Si monomer as2 (polyfunctional) | | Polymerization initiator | | Solvent | |
|---|---|---|---|---|---|---|---|---|---|---|---|---|
| | type | amount | type | amount | type | amount | type | amount | type | amount | type | amount |
| Example 12 | SIM6487.6 | 18.0 | AC-SQ TA-100 | 7.0 | - | | - | | Omnira d 819 | 5.0 | PGME A | 70.0 |
| Example 13 | SIM6487.6 | 14.8 | AC-SQ TA-100 | 10.2 | - | | - | | Omnira d 819 | 0.5 | PGME A | 74.5 |
| Example 14 | SIM6487.6 | 13.7 | AC-SQ TA-100 | 11.3 | - | | - | | Omnira d 819 | 0.1 | PGME A | 74.9 |
| Example 15 | SIM6487.6 | 2.0 | AC-SQ TA-100 | 6.5 | - | | - | | Omnira d 819 | 0.1 | DEG | 91.4 |
| Example 16 | SIM6487.6 | 1.0 | AC-SQ TA- | 7.0 | - | | - | | Omnira d 819 | 1.0 | DEG | 91.0 |
| | | | 100 | | | | | | | | | |
| Example 17 | SIM6487.6 | 18.0 | AC-SQ TA-100 | 10.0 | - | | - | | Omnira d 819 | 1.0 | NMP | 71.0 |
| Example 18 | SIM6487.6 | 18.0 | MAC-SQ TM-100 | 10.0 | - | | - | | Omnira d 819 | 1.0 | PGME A | 71.0 |
| Example 19 | SIM6487.6 | 18.0 | AC-SQ SI-20 | 10.0 | - | | - | | Omnira d 819 | 1.0 | PGME A | 71.0 |
| Example 20 | SIM6487.6 | 18.0 | MAC-SQ SI-20 | 10.0 | - | | - | | Omnira d 819 | 1.0 | PGME A | 71.0 |
| Example 21 | - | | MA-Si-12 | 10.0 | - | | #295 | 10.0 | Omnira d 819 | 1.0 | NMP | 79.0 |
| Example 22 | - | | 8-RING | 10.0 | - | | #295 | 10.0 | Omnira d 819 | 1.0 | NMP | 79.0 |
| Example 23 | - | | 10-RING | 7.0 | - | | DCP-A | 10.0 | Omnira d 819 | 1.0 | NMP | 82.0 |
| Example 24 | - | | AC-SQ TA-100 | 5.0 | Viscoa t #200 | 10.0 | - | | Omnira d 819 | 1.0 | PGME A | 84.0 |
| Example 25 | - | | AC- | 10.0 | Viscoa | 10.0 | - | | Omnira | 1.0 | PGME | 79.0 |
| | | | SQ TA-100 | | t #160 | | | | d 819 | | A | |
| Example 26 | - | | AC-SQ TA-100 | 10.0 | Viscoa t #150 | 10.0 | - | | Omnira d 819 | 1.0 | PGME A | 79.0 |
| Example 27 | SIM6487.6 | 5.0 | - | 0.0 | - | 0.0 | #295 | 20.0 | Omnira d 819 | 1.0 | PGME A | 74.0 |
| Example 28 | SIM6487.6 | 5.0 | - | 0.0 | - | 0.0 | #295 | 20.0 | Omnira d 819 | 1.0 | PGME A | 74.0 |
| Example 29 | SIM6487.6 | 5.0 | - | 0.0 | - | 0.0 | DCP-A | 20.0 | Omnira d 819 | 1.0 | PGME A | 74.0 |
| Example 30 | - | | AC-SQ TA-100 | 10.0 | Viscoa t #150 | 14.0 | - | | Omnira d 819 | 1.0 | PGME A | 75.0 |
| Example 31 | - | | AC-SQ TA-100 | 10.0 | Viscoa t #150 | 10.0 | - | | Omnira d 819 | 1.0 | PGME A | 79.0 |
| Example 32 | - | | AC-SQ TA-100 | 4.0 | Viscoa t #200 | 18.0 | - | | Omnira d 819 | 1.0 | DEG | 77.0 |
| Comparative | SIM6487.6 | 1.0 | AC- | 1.0 | - | | - | | Omnira | 1.0 | PGME | 97.0 |
| Example 4 | | | SQ TA-100 | | | | | | d 819 | | A | |
| Comparative Example 5 | SIM6487.6 | 5.0 | AC-SQ TA-100 | 15.0 | - | | - | | Omnira d819 | 1.0 | DEG | 79.0 |
| Comparative Example 6 | SIM6487.6 | 18.0 | AC-SQ TA-100 | 10.0 | - | | - | | Omnira d 819 | 1.0 | - | 0.0 |
| Comparative Example 7 | SIM6487.6 | 19.0 | AC-SQ TA-100 | 5.0 | - | | - | | Omnira d 819 | 1.0 | PGME A | 75.0 |
| Comparative Example 8 | - | | - | | Viscoa t #160 | 10.0 | DCP-A | 10.0 | Omnira d 819 | 1.0 | DEG | 79.0 |

**[Table 5]**

| | Solvent content in curable composition | Initial viscosity (23°C)/mPa·s | Viscosity when solvent was removed (23°C)/mPa·s | Si atom content of curable composition when solvent was removed/wt.% | Tg after curing of curable composition when solvent was removed/°C |
|---|---|---|---|---|---|
| Example 12 | 70 | 3 | 36 | 20.1 | 135 |
| Example 13 | 75 | 3 | 90 | 22.6 | *155* |
| Example 14 | 75 | 4 | 123 | 22.6 | 162 |
| Example 15 | 91 | 43 | 1131 | 19.8 | 212 |
| Example 16 | 91 | 45 | 2473 | 16.9 | 230 |
| Example 17 | 71 | 5 | 63 | 22.7 | 147 |
| Example 18 | 71 | 3 | 55 | 22.7 | 147 |
| Example 19 | 71 | 3 | 48 | 23.3 | 147 |
| Example 20 | 71 | 3 | 42 | 23.3 | 147 |
| Example 21 | 79 | 4 | 40 | 14.2 | 125 |
| Example 22 | 79 | 4 | 40 | 7.2 | 225 |
| Example 23 | 82 | 4 | 194 | 5.9 | 162 |
| Example 24 | 84 | 2 | 84 | 5.6 | 101 |
| Example 25 | 79 | 3 | 110 | 8.6 | 128 |
| Example 26 | 79 | 3 | 69 | 8.6 | 119 |
| Example 27 | 74 | 3 | 46 | 5.1 | 178 |
| Example 28 | 74 | 3 | 46 | 5.1 | 178 |
| Example 29 | 74 | 3 | 76 | 5.1 | 98 |
| Example 30 | 75 | 3 | 33 | 7.2 | 97 |
| Example 31 | 79 | 3 | 69 | 8.6 | 119 |
| Example 32 | 77 | 32 | 32 | 3.1 | 68 |
| Comparative Example 4 | 97 | 1 | 173 | 14.8 | 170 |
| Comparative Example 5 | 79 | 64 | 1019 | 19.2 | 210 |
| Comparative Example 6 | 0 | 63 | 63 | 22.7 | 147 |
| Comparative Example 7 | 75 | 2 | 22 | 23.7 | 123 |
| Comparative Example 8 | 79 | 28 | 17 | 0.0 | 53 |

**[Table 6]**

| | Evaluation items | | | |
|---|---|---|---|---|
| | discharge | filling property | pattern collapse | dry etching resistance |
| Example 12 | A | A | AA | A |
| Example 13 | AAA | AA | AAA | AA |
| Example 14 | AAA | AAA | AAA | AA |
| Example 15 | A | AA | AAA | B |
| Example 16 | A | A | AAA | B |
| Example 17 | AAA | A | AA | AA |
| Example 18 | AAA | A | AA | AA |
| Example 19 | AAA | A | AA | AAA |
| Example 20 | AAA | A | AA | AAA |
| Example 21 | AAA | A | AA | B |
| Example 22 | AAA | A | AAA | B |
| Example 23 | AAA | AAA | AAA | B |
| Example 24 | A | A | AA | B |
| Example 25 | A | AA | AA | B |
| Example 26 | A | A | AA | B |
| Example 27 | A | A | AAA | B |
| Example 28 | A | A | AAA | B |
| Example 29 | AAA | A | A | B |
| Example 30 | A | A | A | B |
| Example 31 | A | A | AA | B |
| Example 32 | A | A | B | B |
| Comparative Example 4 | B | AAA | AAA | B |
| Comparative Example *5* | B | AA | AAA | B |
| Comparative Example 6 | B | A | AA | AA |
| Comparative Example 7 | A | B | AA | AAA |
| Comparative Example 8 | AA | B | B | B |

This application claims priority from Japanese Patent Application No. 2022-095226 filed June 13, 2022 and Japanese Patent Application No. 2023-092681 filed June 5, 2023, which are hereby incorporated by reference herein.

The present invention is not limited to the above embodiments and various changes and modifications can be made within the spirit and scope of the present invention. Therefore, to apprise the public of the scope of the present invention, the following claims are made.

## Claims

1. A curable composition containing a polymerizable compound, a photopolymerization initiator, and a solvent, **characterized in that**
the polymerizable compound contains a silicon compound having polymerizability,
the curable composition has a viscosity of not less than 2 mPa·s and not more than 60 mPa·s at 23°C,
the curable composition in a state in which the solvent is removed has a viscosity of not less than 30 mPa·s and not more than 10,000 mPa·s at 23°C, and
content of the solvent with respect to the whole curable composition is not less than 5 vol% and not more than 95 vol%.

2. The curable composition according to claim 1, **characterized in that** the content of the solvent with respect to the whole curable composition is not less than 70 vol% and not more than 95 vol%.

3. The curable composition according to claim 1, **characterized in that** the curable composition in the state in which the solvent is removed contains not less than 20 wt% silicon atoms.

4. The curable composition according to claim 1, **characterized in that** a glass transition temperature of a cured product obtained by curing the curable composition in the state in which the solvent is removed is not less than 70°C.

5. The curable composition according to claim 1, **characterized in that** the silicon compound has a silsesquioxane skeleton.

6. The curable composition according to claim 1, **characterized in that** the silicon compound has a cyclic siloxane skeleton.

7. An inverted pattern forming method **characterized by** comprising:
a step of arranging a curable composition defined in any one of claims 1 to 5 to fill recesses of a first film having the recesses and projections and curing the curable composition, thereby forming a second film including an inverted layer filled in the recesses;
a step of removing a part of the second film to expose the projections; and
a step of patterning the first film using the inverted layer remaining in the recesses as a mask, thereby forming an inverted pattern formed by the patterned first film.

8. A film forming method of forming a film of a curable composition in a space between a mold and a substrate, **characterized by** comprising:
an arranging step of discretely arranging a plurality of droplets of a curable composition defined in claim 1 on the substrate;
a waiting step of waiting until the plurality of droplets discretely arranged on the substrate combine with their respective adjacent droplets and form a continuous liquid film on the substrate, a solvent contained in the liquid film volatilizes, and content of the solvent becomes not more than 10 vol% with respect to the whole liquid film; and
a contact step of bringing the mold and the liquid film on the substrate into contact with each other after the waiting step.

9. The film forming method according to claim 8, **characterized in that** in the waiting step, the substrate is heated at not less than 30°C and not more than 200°C for not less than 10 sec and not more than 600 sec.

10. The film forming method according to claim 8, **characterized in that** in the arranging step, droplets each having a volume of not less than 1.0 pL of the curable composition are arranged on the substrate at a density of not less than 130 droplets/mm².

11. The film forming method according to claim 8, **characterized in that** an average liquid film thickness as a value obtained by dividing a volume of the curable composition remaining after the waiting step by an area of a film formation region is not more than 20 nm.

12. The film forming method according to claim 8, **characterized in that**
the mold includes a pattern,
the pattern of the mold and the liquid film on the substrate are brought into contact with each other in the contact step, and
the film forming method further comprises, after the contact step, a curing step of curing the liquid film, thereby forming a cured film having a pattern corresponding to the pattern of the mold.

13. The film forming method according to claim 8, **characterized in that**
the mold includes a flat surface,
the flat surface of the mold and the liquid film on the substrate are brought into contact with each other in the contact step, and
the film forming method further comprises, after the contact step, a curing step of curing the liquid film, thereby forming a cured film having a surface conforming to the flat surface of the mold.

14. A film forming method of forming a film of a curable composition in a space between a mold and a substrate, **characterized by** comprising:
an arranging step of discretely arranging a plurality of droplets of a curable composition defined in claim 1 on the substrate;
a waiting step of waiting until the plurality of droplets discretely arranged on the substrate combine with the respective adjacent droplets and form a continuous liquid film on the substrate, and a solvent contained in the liquid film volatilizes; and
a contact step of bringing the mold and the liquid film on the substrate into contact with each other after the waiting step,
wherein in the waiting step, the substrate is heated at not less than 30°C and not more than 200°C for not less than 10 sec and not more than 600 sec.

15. The film forming method according to claim 8, **characterized in that** in the arranging step, the plurality of droplets are discretely arranged on the substrate by using an inkjet method.

16. An article manufacturing method **characterized by** comprising:
a step of forming a film of a curable composition on a substrate by using a film forming method defined in any one of claims 8 to 15;
a step of processing the substrate on which the film is formed in the step of forming; and
a step of manufacturing an article from the processed substrate.
